(19) Europäisches Patentamt
European Patent Office
Office européen des brevets

(11) EP 4 199 133 A1

(12) **EUROPEAN PATENT APPLICATION**

(43) Date of publication:
**21.06.2023 Bulletin 2023/25**

(21) Application number: **21216026.1**

(22) Date of filing: **20.12.2021**

(51) International Patent Classification (IPC):
***H01L 51/54*** *(2006.01)*

(52) Cooperative Patent Classification (CPC):
**H10K 85/615; H10K 85/654; H10K 85/6572;**
H10K 50/16; H10K 50/19

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Novaled GmbH**
**01099 Dresden (DE)**

(72) Inventors:
- **Jerome, GANIER c/o Novaled GmbH 01099 Dresden (DE)**
- **Elena, GALÁN GARCÍA c/o Novaled GmbH 01099 Dresden (DE)**
- **Benjamin, SCHULZE c/o Novaled GmbH 01099 Dresden (DE)**
- **Regina, LUSCHTINETZ c/o Novaled GmbH 01099 Dresden (DE)**
- **Qiang, HUANG c/o Novaled GmbH 01099 Dresden (DE)**
- **Mauro, FURNO c/o Novaled GmbH 01099 Dresden (DE)**
- **Steffen, RUNGE c/o Novaled GmbH 01099 Dresden (DE)**

(74) Representative: **Bittner, Thomas L.**
**Boehmert & Boehmert Anwaltspartnerschaft mbB**
**Pettenkoferstrasse 22**
**80336 München (DE)**

(54) **ORGANIC LIGHT EMITTING DIODE, DISPLAY DEVICE COMPRISING THE SAME, AND COMPOUND**

(57) The present invention relates to an organic light emitting device, a display device comprising the same and to a compound.

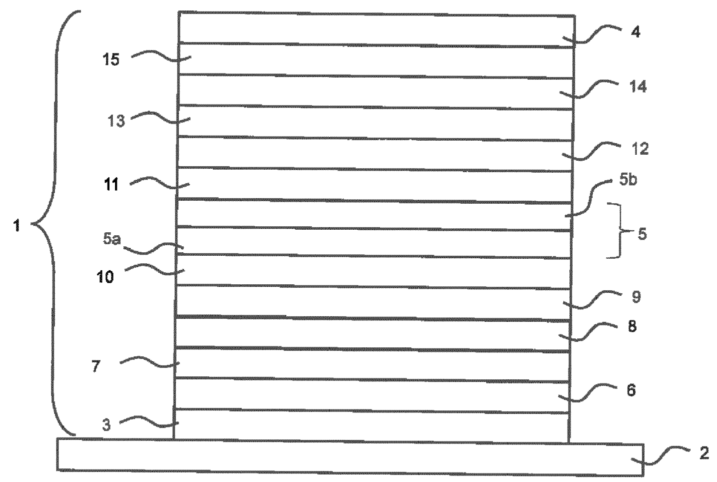


Fig. 1

EP 4 199 133 A1

## Description

TECHNICAL FIELD

The present invention relates to an organic light emitting diode and a display device comprising the same. The invention further relates to a compound.

BACKGROUND ART

Organic light-emitting diodes (OLEDs), which are self-emitting devices, have a wide viewing angle, excellent contrast, quick response, high brightness, excellent driving voltage characteristics, and color reproduction. A typical OLED includes an anode, a hole transport layer (HTL), an emission layer (EML), an electron transport layer (ETL), and a cathode, which are sequentially stacked on a substrate. In this regard, the HTL, the EML, and the ETL are thin films formed from organic and / or organometallic compounds.

When a voltage is applied to the anode and the cathode, holes injected from the anode electrode move to the EML, via the HTL, and electrons injected from the cathode electrode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency.

Further known in the art are OLEDs comprising between the two electrodes two or more emission layers. Such OLEDs are called tandem OLEDs. In such tandem OLEDs charge generation layers are comprised between two emission layers, wherein n-type charge generation layers provide electrons to the light emission layer arranged closer to the anode while p-type generation layers provide holes to the light emission layer arranged near the cathode. A variety of materials for preparing such charge generation layers is known in the art.

However, there is still a need to improve the performance of organic light emitting diodes or materials comprised therein, in particular to improve the performance of (tandem) organic light emitting diodes comprising charge generation layers with respect to operating voltage, efficiency and/or voltage stability.

It is, therefore, the object of the present invention to provide organic light emitting devices overcoming the drawbacks of the prior art, in particular to provide organic light emitting devices with lowered operating voltage and/or improved efficiency and/or improved voltage stability.

SUMMARY OF THE INVENTION

The above object is achieved by an organic light emitting device comprising an anode, a cathode, a first emission layer, a second emission layer, a charge generation layer and a first electron transport layer, wherein

- the charge generation layer is arranged between the first emission layer and the second emission layer;
- the charge generation layer comprises a n-doped sublayer;
- the n-doped sublayer comprises a metal and a n-doped sublayer matrix material;
- the n-doped sublayer matrix material comprises
- a first structural moiety $R^a$, wherein $R^a$ is selected from the group consisting of phosphine oxide and substituted or unsubstituted pyridine, and
- a second structural moiety $R^b$, wherein $R^b$ is a heteroaryl group comprising two nitrogen atoms in one ring thereof;
- the first electron transport layer is arranged adjacent to the n-doped sublayer and in direct contact therewith;
- the first electron transport layer is non-emissive;
- the first electron transport layer consists of a first electron transport layer matrix material;
- the first electron transport layer matrix material does not comprise an n-dopant; and
- the first electron transport layer matrix material does not comprise the n-doped sublayer matrix material.

The object is further achieved by a display device comprising the organic light emitting device according to the invention.

Finally, the object is achieved by a compound having a formula selected from E2, G2 to G5, G7, and G9 to G11

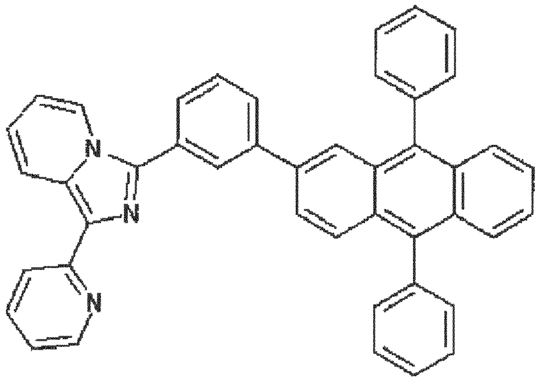

E2

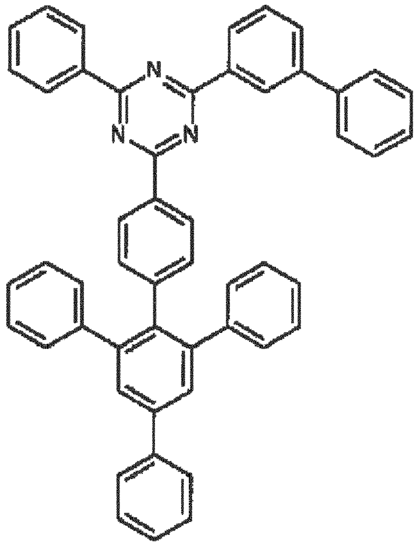

G2

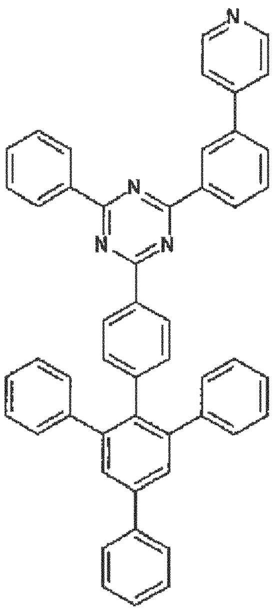

G3

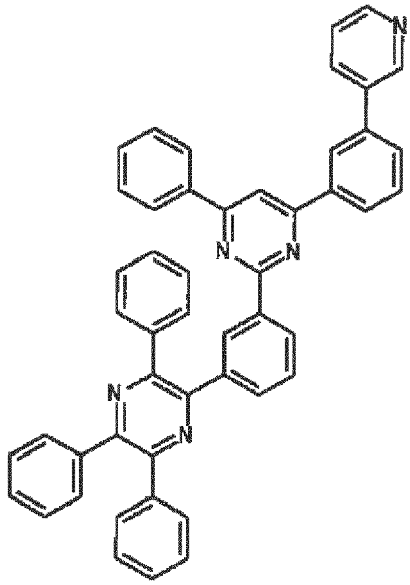

G4

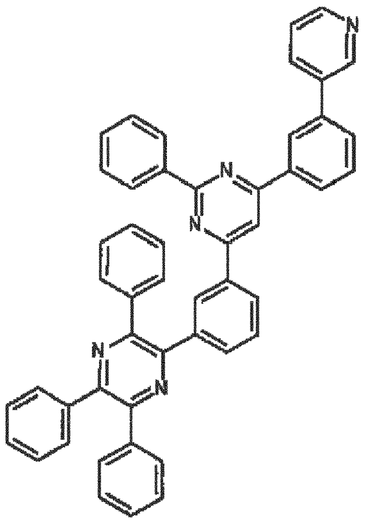

G5

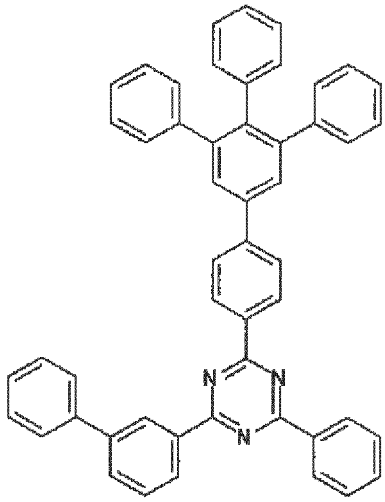

G7

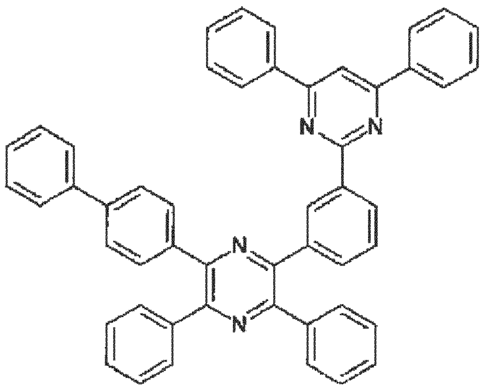

G9

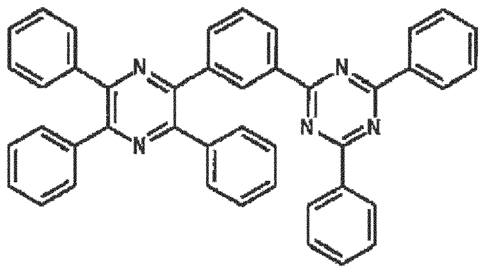

G10

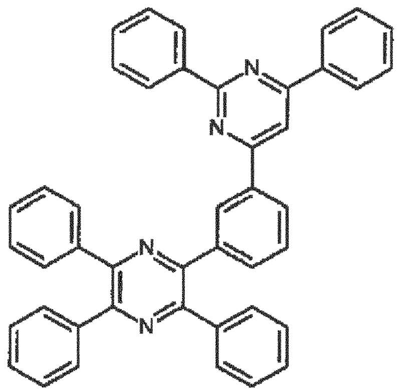

G11.

Organic light emitting device

The organic light emitting device according to the invention comprises a first emission layer, a second emission layer, a charge generation layer and a first electron transport layer. Referring to "a" respective layer does only mean in terms of the present disclosure that the organic light-emitting device comprises at least this layer, that is, at least one of the respective layers. The presence of further layers of the same kind is not excluded. The same applies for further possible layers of the organic light emitting device referred to herein if not explicitly mentioned else. Further layers and possible layer arrangements are disclosed below in detail.

Charge generation layer

The charge generation layer is arranged between the first emission layer and the second emission layer. The charge generation layer comprises a n-doped sublayer (n-type sub-layer; n-type charge generation layer). The charge generation layer may further comprise a p-doped sublayer (p-type sublayer). The n-doped sublayer provides electrons to the light emission layer arranged closer to the anode while the p-doped sublayer provides holes to the light emission layer arranged near the cathode.

The n-doped sublayer comprises a metal. The metal may be an electropositive metal. The metal may be selected from alkali metals, alkaline earth metals, transition metals of the third period of the Periodic Table, and rare earth metals, such as Li, Na, Mg, Ca, Sr, Ba, Eu and Yb, in particular Li, Na, Mg, Ca, Sr and Yb, alternatively as Li, Na and Yb, especially Yb, or mixtures of two or more of the foregoing. The metal comprised in the n-doped sublayer is an n-dopant, that is, an electrical dopant improving the transport of electrons in the sublayer.

The n-doped sublayer further comprises a n-doped sublayer matrix material. The n-doped sublayer matrix material may be the predominant material in the n-doped sublayer, that is, may be comprised in an amount selected from the group consisting of at least 50 wt.%, at least 60 wt.%, at least 70 wt.%, at least 80 wt.%, at least 90 wt.%, at least 95 wt.%, at least 98 wt.%, at least 99 wt.%, with respect to the total weight of the n-doped sublayer matrix material, respectively.

The n-doped sublayer matrix material may be a single compound, such as an organic compound or a mixture of two or more compounds, such as two or three compounds. The compounds forming the n-doped sublayer matrix material are referred to herein as n-doped sublayer matrix compounds, such as the first n-doped sublayer matrix compound, the second n-doped sublayer matrix compound etc. The n-doped sublayer matrix material may consist of a single n-doped sublayer matrix compound or may consist of a mixture of two or more, such as two or three, n-doped sublayer matrix compounds. The n-doped sublayer matrix material may consist of a (single) n-doped sublayer matrix compound and the n-doped sublayer matrix compound comprises, especially consists of, $R^a$, $R^b$ and, if present, $R^c$. "If present" in this regard means that this group is part of the compound in the embodiments in which a group $R^c$ is foreseen.

The n-doped sublayer matrix material comprises a first structural moiety $R^a$, wherein $R^a$ is selected from the group consisting of phosphine oxide and substituted or unsubstituted pyridine. The n-doped sublayer matrix material comprises further a second structural moiety $R^b$, wherein $R^b$ is a heteroaryl group comprising two nitrogen atoms in one ring thereof. The two structural moieties $R^a$ and $R^b$ may be comprised in only one single n-doped sublayer matrix compound comprised in or forming the n-doped sublayer matrix material. If the n-doped sublayer matrix material comprises or is formed of a mixture of two or more, such as two or three, n-doped sublayer matrix compounds, the two structural moieties $R^a$ and $R^b$ may be comprised in only one single of the n-doped sublayer matrix compounds forming the mixture or the first structural moiety $R^a$ is comprised in a first n-doped sublayer matrix compound and the second structural moiety $R^b$ is comprised in a second n-doped sublayer matrix compound. The phosphine oxide group in the n-doped sublayer matrix material may be selected from the group consisting of aryl-containing phosphine oxide, heteroaryl-containing phosphine oxide, alkyl-containing phosphine oxide and alkylaryl-containing phosphine oxide. The phosphine oxide group may be a group comprising a structural fragment P=O to which two $sp^3$ hypridized C atoms are directly linked, such as dialkylphosphine oxide or dialkylarylphosphine oxide, especially dialkylphosphine oxide. The phosphine oxide group may be selected from the group consisting of di-$C_1$ to $C_{10}$-alkylphosphine oxide, di-$C_1$ to $C_8$-alkylphosphine oxide, di-$C_1$ to $C_6$-alkylphosphine oxide, di-$C_1$ to $C_4$-alkylphosphine oxide, di-$C_1$ to $C_3$-alkylphosphine oxide, di-$C_1$ to $C_2$-alkylphosphine oxide, especially may be dimethylphosphine oxide.

The pyridine group in the n-doped sublayer matrix material is a non-condensed pyridine group. In condensed (also called "fused") bicyclic compounds (or bicyclic moieties), two rings share two adjacent atoms. In other words, the pyridine group in the n-doped sublayer matrix material is not part of a condensed ring system, such as quinoline, acridine and the like.

The pyridine may be substituted or unsubstituted. In case that the pyridine is substituted, the substituents may be independently selected from the group consisting of $C_6$ to $C_{12}$ aryl, $C_3$ to $C_{11}$ heteroaryl, and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; wherein each $C_6$ to $C_{12}$ aryl substituent on $Ar^1$ and each $C_3$ to $C_{11}$ heteroaryl substituent on $Ar^1$ may be substituted with $C_1$ to $C_4$ alkyl or halogen. It is excluded that the substituents form another aromatic ring condensed to the pyridine ring.

The second structural moiety $R^b$, that is, the heteroaryl group comprising two nitrogen atoms in one ring thereof may be selected from the group consisting of a $C_2$ to $C_{42}$ hetroaryl comprising two nitrogen atoms in one ring thereof, a $C_2$ to $C_{40}$ hetroaryl comprising two nitrogen atoms in one ring thereof, a $C_2$ to $C_{36}$ hetroaryl comprising two nitrogen

atoms in one ring thereof, a $C_2$ to $C_{30}$ hetroaryl comprising two nitrogen atoms in one ring thereof, and a $C_2$ to $C_{24}$ hetroaryl comprising two nitrogen atoms in one ring thereof, wherein the group may be substituted or unsubstituted, respectively. In case that the heteroaryl group comprising two nitrogen atoms in one ring thereof is substituted, the substituents may be independently selected from the group consisting of $C_6$ to $C_{12}$ aryl, $C_3$ to $C_{11}$ heteroaryl, and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; wherein each $C_6$ to $C_{12}$ aryl substituent on $Ar^1$ and each $C_3$ to $C_{11}$ heteroaryl substituent on $Ar^1$ may be substituted with $C_1$ to $C_4$ alkyl or halogen.

The second structural moiety $R^b$, that is, the heteroaryl group comprising two nitrogen atoms in one ring thereof, may be selected from the group consisting of diazine, especially non-condensed diazine, diazole, especially non-condensed diazole, benzimidazole, imidazopyridine, quinazoline and quinoxaline, which may be unsubstituted or substituted, respectively, with one or more of the substituents given above for the second structural moiety $R^b$.

The n-doped sublayer matrix material may comprise a third structural moiety $R^c$, wherein $R^c$ is selected from the group consisting of $C_6$ to $C_{60}$ aryl or $C_2$ to $C_{42}$ heteroaryl, alternatively $C_6$ to $C_{54}$ aryl or $C_2$ to $C_{39}$ heteroaryl, alternatively $C_6$ to $C_{48}$ aryl or $C_2$ to $C_{36}$ heteroaryl, alternatively $C_6$ to $C_{42}$ aryl or $C_2$ to $C_{36}$ heteroaryl, alternatively $C_6$ to $C_{36}$ aryl or $C_2$ to $C_{30}$ heteroaryl, alternatively $C_6$ to $C_{30}$ aryl or $C_2$ to $C_{24}$ heteroaryl.

The n-doped sublayer matrix material may comprise a third structural moiety $R^c$, wherein $R^c$

- is $C_6$ to $C_{60}$ and comprises 2 to 6 condensed aromatic rings; or

- is $C_2$ to $C_{42}$ heteroaryl and is represented by the following formula (IIb)

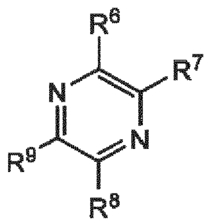

(IIb)

wherein $R^6$ to $R^9$ are independently selected from the group consisting of H, $C_6$ to $C_{12}$ aryl and $C_4$ to $C_{10}$ heterorayl.

The n-doped sublayer matrix material may comprise a third structural moiety $R^c$, wherein $R^c$ comprises a group selected from the group consisting of anthracene, phenanthrene, pyrene and a group of the following formula (IIb)

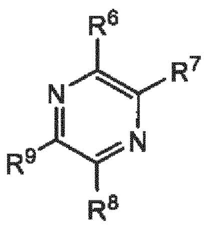

(IIb)

wherein $R^6$ to $R^9$ are phenyl.

$R^c$ may be substituted or unsubstituted. In case that the $R^c$ is substituted, the substituents may be independently selected from the group consisting of $C_6$ to $C_{12}$ aryl, $C_3$ to $C_{11}$ heteroaryl, and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; wherein each $C_6$ to $C_{12}$ aryl substituent on $Ar^1$ and each $C_3$ to $C_{11}$ heteroaryl substituent on $Ar^1$ may be substituted with $C_1$ to $C_4$ alkyl or halogen. Especially, in case that $R^c$ is substituted, the one or more substituents may

be independently selected from $C_6$ to $C_{12}$ aryl, $C_1$ to $C_6$ alkyl, $C_3$ to $C_{11}$ heteroaryl, $PO(R^{10})_2$ $R^{10}$ being $C_1$ to $C_4$ alkyl or $C_6$ aryl, and CN.

It may be provided that the n-doped sublayer matrix material comprises not more than one phosphine oxide group (per respective molecule).

the n-doped sublayer matrix compound is represented by formula (III) or formula (IV)

$R^1$-$R^2$-$R^3$ (III);

$R^1$-$R^3$-$R^2$ (IV).

In this regard, the moieties are connected with each other via single bonds as shown in the formula by "-". The respective groups $R^1$, $R^2$ and $R^3$ maybe unsubstituted or may be substituted with one or more substituent(s) listed above.

The n-doped sublayer matrix compound may be selected from the following structures E1 to E3

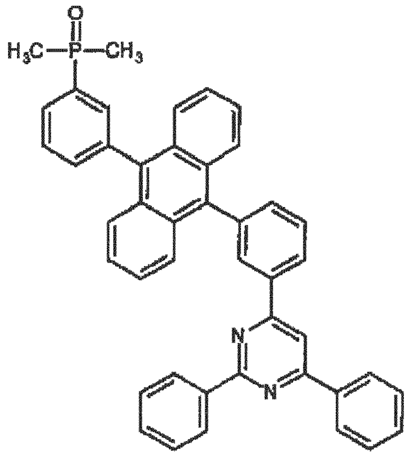

E1

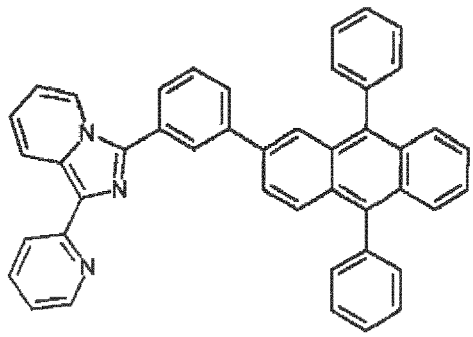

E2

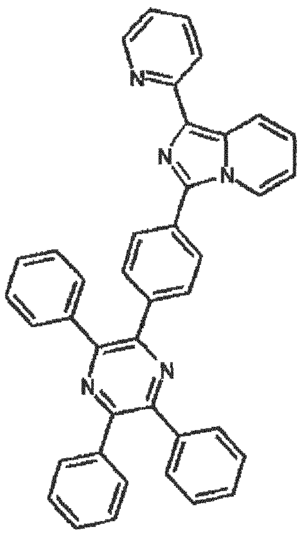

E3.

It may be provided that the n-doped sublayer matrix material does not comprise a phenanthroline structural moiety, especially does not comprise a metal chelating phenanthroline structural moiety.

It may be provided that the n-doped sublayer matrix material does not comprise a pyrido[3,2-h]quinazoline structural moiety, especially does not comprise a metal chelating pyrido[3,2-h]quinazoline structural moiety.

It may be provided that the n-doped sublayer matrix material does not comprise a terpyridyl structural moiety structural moiety, especially does not comprise a metal chelating terpyridyl structural moiety.

It may be provided that the n-doped sublayer matrix material does not comprise a bipyridyl structural moiety structural moiety, especially does not comprise a metal chelating bipyridyl structural moiety.

It may be provided that the n-doped sublayer matrix material does not comprise a pyridyl-imidazopyridine

structural moiety, especially does not comprise a metal chelating pyridyl-imidazopyridine structural moiety.

If the n-doped sublayer matrix material consists only of one single n-doped sublayer matrix compound, the n-doped sublayer matrix compound may comprise only one non-condensed pyridine group.

First electron transport layer

The organic light emitting device according to the invention comprises a first electron transport layer. The first electron transport layer may be adjacent and in direct contact with the n-doped sublayer.

The first electron transport layer is non-emissive. In this context, non-emissive may be "essentially non-emissive". In this context essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about $\geq$ 380 nm to about $\leq$ 780 nm.

The first electron transport layer matrix material does not comprise the n-doped sublayer matrix material, that is, does not comprise one or more of the electron transport layer matrix compound(s) comprised therein. In addition, the first electron transport layer matrix material does not comprise an n-dopant. The term "does not comprise" does not exclude impurities. Impurities have no technical effect with respect to the object achieved by the present invention.

In particular, the first electron transport layer is free of an electrical dopant. In this regard, "free of" means that respective compounds (electrical dopants) are only contained in the respective layers which cannot be avoided by standard purification methods and common technical means during preparation of the respective layer. In this regards, electrical dopants are in particular, but not limited thereto, electrical n-dopants. The electrical n-dopant may be selected from a metal, alternatively an alkali metal, a metal salt alternatively an alkaline earth metal salt and/or rare earth metal salt, or an organic alkali metal complex, alternatively an alkali metal complex, alternatively LiF, LiCl, LiBr, LiI, LiQ, a metal borate, or mixtures thereof. In particular, the first electron transport layer and the second electron transport layer may be free of an electrical n-dopant. The electrical n-dopant may be a metal salt comprising at least one metal cation and at least one anion. The metal cation of the metal salt may be selected from the group consisting of alkali metals, alkaline earth metals and rare earth metals, alternatively from the group consisting of Li, Na, K, Rb, Cs, Mg, Ca, Sr, and Ba; alternatively from Li, Mg, Ca, and Sr. The anion of the metal salt may be selected from the group consisting of quinolinolate, phosphine oxide phenolate and borate.

In this regard, electrical n-dopants are in particular, but not limited thereto, an elemental metal, alternatively an electropositive metal selected from alkali metals, alkaline earth metals, rare earth metals and transition metals, transition metals; a metal salt, alternatively an alkali metal salt, alkaline earth metal salt and/or rare earth metal salt, or a metal complex, alternatively an alkali metal complex, alkaline earth metal complex, transition metal complex and/or rare earth metal complex. Examples of n-doping metal salts can be LiF, LiCl, LiBr, LiI, metal borates, metal quinolinolates or mixtures thereof. Further examples of electrical n-dopants are strong chemical reducing agents. This class of "redox" n-dopants may be generically characterized by energy level of the highest occupied molecular orbital (HOMO) comparable with lowest unoccupied molecular orbital Energy Level of corresponding electron transport matrices, which is in usual OLED transport materials about -3.0 eV or less. It is to be understood that the term "about -3.0 eV or less" means less negative values than -3.0 eV, for example -2.8 eV, -2.5 eV, -2.3 eV, -2.1 eV or vales less negative than -2.0 eV.

Electrical n-dopants may be organic compounds as disclosed in EP1837926A1, WO07107306A1 or WO07107356A1.

The first electron transport layer matrix material may be a single compound, such as an organic compound or a mixture of two or more compounds, such as two or three compounds. The compounds forming the first electron transport layer matrix material are referred to herein as electron transport layer matrix compound, such as the first electron transport layer matrix compound, the second electron transport layer matrix compound etc. The first electron transport layer matrix material may consist of a first electron transport layer matrix compound or may consist of a mixture of two or more, such as two or three, first electron transport layer matrix compounds.

The first electron transport layer matrix material may comprise (or consist of) a first electron transport layer matrix compound of Formula (I)

$$(Ar^1\text{-}A_c)_a\text{-}X_b \qquad (I);$$

wherein

- a and b are independently 1 or 2;
- c is independently o or 1;
- $Ar^1$ is independently selected from $C_6$ to $C_{60}$ aryl or $C_2$ to $C_{42}$ heteroaryl,

- wherein each $Ar^1$ may be substituted with one or two substituents independently selected from the group consisting of $C_6$ to $C_{12}$ aryl, $C_3$ to $C_{11}$ heteroaryl, and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;

- wherein each $C_6$ to $C_{12}$ aryl substituent on $Ar^1$ and each $C_3$ to $C_{11}$ heteroaryl substituent on $Ar^1$ may be substituted with $C_1$ to $C_4$ alkyl or halogen;

- A is independently selected from $C_6$ to $C_{30}$ aryl,

  - wherein each A may be substituted with one or two substituents independently selected from the group consisting of $C_6$ to $C_{12}$ aryl and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;

  - wherein each $C_6$ to $C_{12}$ aryl substituent on A may be substituted with $C_1$ to $C_4$ alkyl or halogen; and

- X is independently selected from the group consisting of $C_2$ to $C_{42}$ heteroaryl and $C_6$ to $C_{60}$ aryl,

  - wherein each X may be substituted with one or two substituents independently selected from the group consisting of $C_6$ to $C_{12}$ aryl, $C_3$ to $C_{11}$ heteroaryl, and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and

  - wherein each $C_6$ to $C_{12}$ aryl substituent on X and each $C_3$ to $C_{11}$ heteroaryl substituent on X may be substituted with $C_1$ to $C_4$ alkyl or halogen.

In the compound of Formula (I), the group "A" is spacer moiety connecting (if present, that is in case that $c \geq 1$) the group $Ar^1$ and X. In case that the compound of Formula (I) comprises more than one groups ($Ar^1$-$A_c$), the groups may or may not independently comprise the spacer A.

In the compound of Formula (I), a and b are independently 1 or 2. Alternatively, a and b may both be 1.

In the compound of Formula (I), c is independently 0 or 1.

$Ar^1$ is independently selected from $C_6$ to $C_{60}$ aryl or $C_2$ to $C_{42}$ heteroaryl, alternatively $C_6$ to $C_{54}$ aryl or $C_2$ to $C_{39}$ heteroaryl, alternatively $C_6$ to $C_{48}$ aryl or $C_2$ to $C_{36}$ heteroaryl, alternatively $C_6$ to $C_{42}$ aryl or $C_2$ to $C_{36}$ heteroaryl, alternatively $C_6$ to $C_{36}$ aryl or $C_2$ to $C_{30}$ heteroaryl, alternatively $C_6$ to $C_{30}$ aryl or $C_2$ to $C_{24}$ heteroaryl which may be substituted or unsubstituted, wherein in case that the respective $Ar^1$ group is substituted, the one or more substituent(s) may be independently selected from the substituents listed above for $Ar^1$.

$Ar^1$ may be independently $C_6$ to $C_{54}$ aryl, optionally $C_6$ to $C_{48}$ aryl, optionally $C_6$ to $C_{42}$ aryl, optionally $C_6$ to $C_{36}$ aryl, optionally $C_6$ to $C_{30}$ aryl, and optionally $C_6$ to $C_{24}$ aryl which may be substituted or unsubstituted, wherein in case that the respective $Ar^1$ group is substituted, the one or more substituent(s) may be independently selected from the substituents listed above for $Ar^1$.

$Ar^1$ may be independently $C_2$ to $C_{42}$ hetroaryl, optionally $C_2$ to $C_{40}$ hetroaryl, optionally $C_2$ to $C_{36}$ hetroaryl, optionally $C_2$ to $C_{30}$ hetroaryl, and optionally $C_2$ to $C_{24}$ hetroaryl which may be substituted or unsubstituted, wherein in case that the respective $Ar^1$ group is substituted, the one or more substituent(s) may be independently selected from the substituents listed above for $Ar^1$.

$Ar^1$ may comprise a system of two or more anellated aromatic rings, preferably three or more anellated aromatic

rings.

$Ar^1$ may comprise at least one $sp^3$-hypridized carbon atom.

$Ar^1$ may comprise at least one carbon-carbon $sp^2$ alkene bond which is not integrated into an aromatic ring structure. In an embodiment where $Ar^1$ is independently selected from unsubstituted $C_2$ to $C_{42}$ heteroaryl, the heteroatoms are bound into the molecular structure of $Ar^1$ by single bonds.

$Ar^1$ may be independently selected from the group consisting of phenyl, naphthyl, anthracenyl, phenylanthracenyl phenyl-phenathrolinyl, phenathrolinyl,fluoranthenyl, xanthenyl, dibenzofuranyl, dibenzoacridinyl, phenyldibenzoacridinyl, pyrimidinyl pyraziny, spiro-xanthenyl, fluorenyl, spiro-fluorenyl, triphenylsilyl, tetraphenylsilyl, tetraphenylethylene, or a group having the formula (IIa) or (IIb)

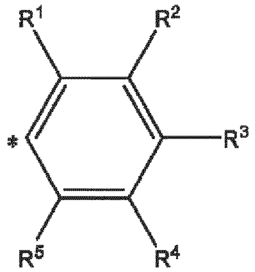 (IIa) 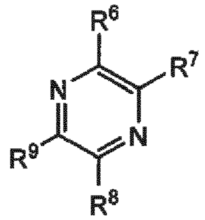 (IIb)

wherein

- the asterisk symbol "*" represents the binding position for binding the group of formula (IIa) to A; and
- $R^1$ to $R^9$ are independently selected from the group consisting of H, $C_6$ to $C_{12}$ aryl and $C_4$ to $C_{10}$ heterorayl

which may be substituted or unsubstituted, wherein in case that the respective $Ar^1$ group is substituted, the one or more substituent(s) may be independently selected from the substituents listed above for $Ar^1$.

$Ar^1$ may be independently selected from the group consisting of phenylanthracenyl dibenzoacridinyl, phenylphenathrolinyl, 9,9'-dimethylfluorenyl, and a group having the formula (IIa) or (IIb)

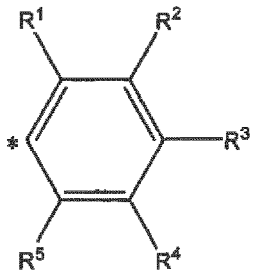 (IIa) 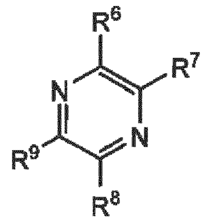 (IIb)

wherein

- the asterisk symbol "*" represents the binding position for binding the group of formula (IIa) to A; and
- $R^1$ is H and $R^2$ to $R^5$ are independently phenyl; or
- $R^1$, $R^3$ and $R^5$ are phenyl and $R^2$ and $R^4$ are H; or
- $R^2$, $R^3$ and $R^4$ are phenyl and $R^1$ and $R^5$ are H; or
- $R^6$ to $R^9$ are phenyl; or
- $R^6$ to $R^8$ are phenyl and $R^9$ is biphenyl

which may be substituted or unsubstituted, wherein in case that the respective $Ar^1$ group is substituted, the one or more

substituent(s) may be independently selected from the substituents listed above for $Ar^1$.

If $Ar^1$ is a group having the formula (IIb), binding of the group having the formula (IIb) to A (or if A is not present in case that c =o) to X may be via any of the groups $R^6$ to $R^9$ wherein (formally) A (respectively X) replaces a terminal hydrogen atom of the respective $R^6$ to $R^9$.

In the group of Formula (IIa), at least two of $R^1$ to $R^5$, which are not H may be in ortho-position to each other. At least one of $R^1$ to $R^5$ which is not H may be in ortho-position to the *-position. In this regard, two groups are in ortho-position to each other if bound to adjacent carbon atoms of the benzene ring in Formula (IIa), respectively. In other words, it can be provided that at least one of $R^1$ and $R^5$ is phenyl; and/or $R^1$ and $R^2$ are both phenyl; and/or $R^2$ and $R^3$ are both phenyl; and/or $R^3$ and $R^4$ are both phenyl; and/or $R^4$ and $R^5$ are both phenyl.

A may be selected independently from the group consisting of phenylene, naphthylene, phenyl-naphthylene, biphenylene, phenyl-phenanthrene and terphenylene which may be substituted or unsubstituted, respectively, wherein in case that the respective A group is substituted, the one or more substituent(s) may be independently selected from the substituents listed above for A.

A may be selected independently from one of the following groups

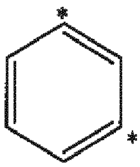 ; 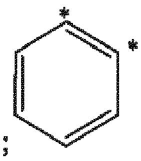 ; 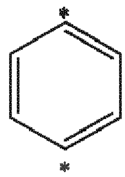 ; 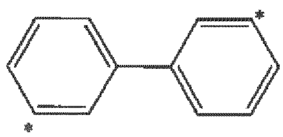 ; 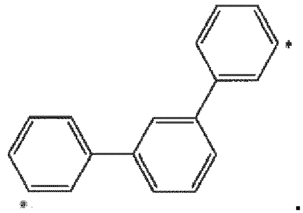 ;

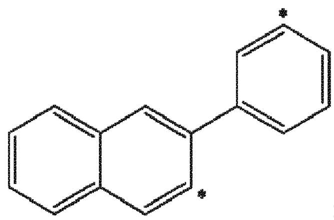 ; 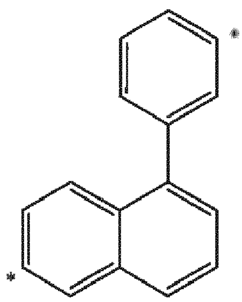 ; 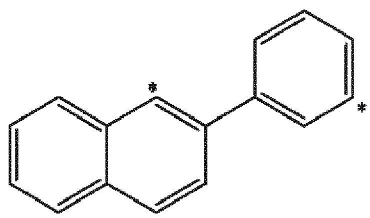 ;

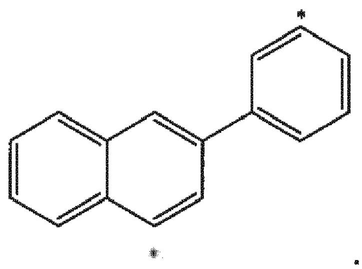 ; 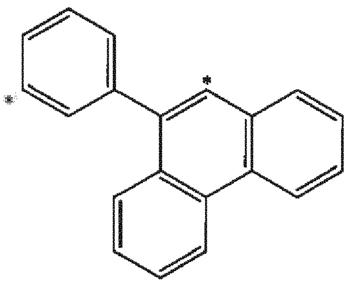 ;

wherein the asterisk symbol "*" represents the binding position for binding the to $Ar^1$ and X, respectively and which may be substituted or unsubstituted, respectively, wherein in case that the respective A group is substituted, the one or more substituent(s) may be independently selected from the substituents listed above for A.

X may be independently selected from the group consisting of $C_2$ to $C_{39}$ heteroaryl and $C_6$ to $C_{54}$ aryl, optionally $C_2$ to $C_{36}$ heteroaryl and $C_6$ to $C_{48}$ aryl, optionally $C_3$ to $C_{30}$ heteroaryl and $C_6$ to $C_{42}$ aryl, optionally $C_3$ to $C_{27}$ heteroaryl and $C_6$ to $C_{36}$ aryl, optionally $C_3$ to $C_{24}$ heteroaryl and $C_6$ to $C_{30}$ aryl, and optionally $C_3$ to $C_{21}$ heteroaryl and $C_6$ to $C_{24}$ aryl, wherein the respective group may be substituted or unsubstituted, wherein in case that the respective X group is substituted, the one or more substituent(s) may be independently selected from the substituents listed above for X.

X may be independently selected from the group consisting of $C_2$ to $C_{39}$ N-containing heteroaryl, $C_2$ to $C_{39}$ O-containing heteroaryl and $C_6$ to $C_{54}$ aryl, optionally $C_2$ to $C_{36}$ N-containing heteroaryl, $C_2$ to $C_{36}$ O-containing heteroaryl and $C_6$ to $C_{48}$ aryl, optionally $C_3$ to $C_{30}$ N-containing heteroaryl, $C_3$ to $C_{30}$ O-containing heteroaryl and $C_6$ to $C_{42}$ aryl, optionally $C_3$ to $C_{27}$ N-containing heteroaryl, $C_3$ to $C_{27}$ O-containing heteroaryl and $C_6$ to $C_{36}$ aryl, optionally $C_3$ to $C_{24}$

N-containing heteroaryl, $C_3$ to $C_{24}$ O-containing heteroaryl and $C_6$ to $C_{30}$ aryl, and optionally $C_3$ to $C_{21}$ N-containing heteroaryl, $C_3$ to $C_{21}$ O-containing heteroaryl and $C_6$ to $C_{24}$ aryl, wherein the respective group may be substituted or unsubstituted, wherein in case that the respective X group is substituted, the one or more substituent(s) may be independently selected from the substituents listed above for X.

X may be independently selected from the group consisting of $C_2$ to $C_{39}$ N-containing heteroaryl and $C_6$ to $C_{54}$ aryl, optionally $C_2$ to $C_{36}$ N-containing heteroaryl, and $C_6$ to $C_{48}$ aryl, optionally $C_3$ to $C_{30}$ N-containing heteroaryl and $C_6$ to $C_{42}$ aryl, optionally $C_3$ to $C_{27}$ N-containing heteroaryl and $C_6$ to $C_{36}$ aryl, optionally $C_3$ to $C_{24}$ N-containing heteroaryl and $C_6$ to $C_{30}$ aryl, and optionally $C_3$ to $C_{21}$ N-containing heteroaryl and $C_6$ to $C_{24}$ aryl. In this regard, it may be provided that a respective N-containing heteroaryl comprises one or more N-atoms as the only heteroatom(s), wherein the respective group may be substituted or unsubstituted, wherein in case that the respective X group is substituted, the one or more substituent(s) may be independently selected from the substituents listed above for X.

X may be independently selected from the group consisting of triazinyl, 1,2-diazinyl, 1,3-diazinyl, 1,4-diazinyl, pyridinyl, bipyridinyl, phenathrolinyl, phenyl-phenathrolinyl, quinazolinyl, benzoquinazolinyl, benzimidazolyl, quinolinyl, benzoquinolinyl benzoacridinyl, dibenzoacridinyl, fluoranthenyl, anthracenyl, naphthyl, triphenylenyl, phenathrolinyl, and dinaphthofuranyl which may be substituted or unsubstituted, respectively, wherein in case that the respective X group is substituted, the one or more substituent(s) may be independently selected from the substituents listed above for X.

X may be independently selected from the group consisting of triazinyl, 1,3-diazinyl, 1,4-diazinyl, bipyridinyl, phenathrolinyl, phenyl-phenathrolinyl, dibenzoacridinyl, which may be substituted or unsubstituted, respectively, wherein the one or more substituents are independently selected from phenyl, phenyl-pyridinyl, biphenyl, pyridinyl, and methyl-substituted biphenyl.

X may be selected independently from one of the following groups

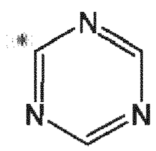 ; 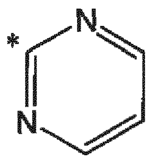 ; 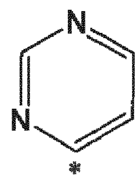 ; 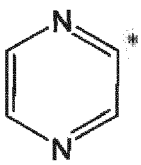 ; 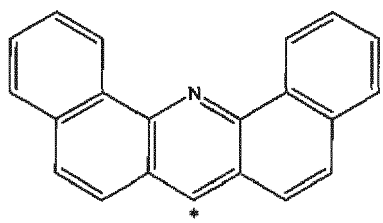 ; 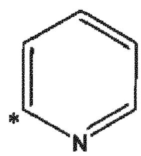

and

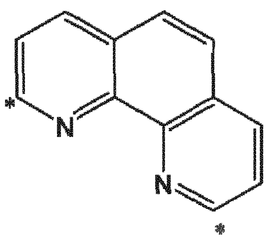

wherein the asterisk symbol "*" represents the binding position for binding the group to A, respectively; and the group may be substituted or unsubstituted, respectively, especially with phenyl, phenyl-pyridinyl, biphenyl, pyridinyl, and methyl-substituted biphenyl.

In one embodiment, the first electron transport compound may be a compound having the Formula (II)

$$E\text{-}A^1\text{-}A^2\text{-}A^3 \qquad (II),$$

wherein in Formula (II)

- E is selected from the group consisting of a substituted or unsubstituted $C_4$-$C_{70}$ heteroaryl comprising a diazine group, a substituted or unsubstituted $C_3$-$C_{70}$ heteroaryl comprising a triazine group, a $C_{10}$-$C_{70}$ aryl comprising at least two condensed benzene rings, and a $C_4$-$C_{70}$ heteroaryl comprising at least two condensed aromatic rings;

  - wherein in case that E is substituted or unsubstituted $C_4$-$C_{70}$ heteroaryl comprising a diazine group E is bonded to $A^1$ via a direct bond between $A^1$ and the diazine group;

- wherein in case that E is substituted or unsubstituted $C_4$-$C_{70}$ heteroaryl comprising a triazine group E is bonded to $A^1$ via a direct bond between $A^1$ and the triazine group;

- wherein in case that E is $C_{10}$-$C_{70}$ aryl comprising at least two condensed benzene rings E is bonded to $A^1$ via a direct bond between $A^1$ and one of the condensed benzene rings; and

- wherein in case that E is $C_4$-$C_{70}$ heteroaryl comprising at least two condensed aromatic rings E is bonded to $A^1$ via a direct bond between $A^1$ and one of the condensed aromatic rings;

- $A^1$ is selected from the group consisting of a substituted or unsubstituted $C_{10}$-$C_{70}$ arylene comprising 2 or 3 condensed rings and a substituted or unsubstituted $C_2$-$C_{70}$ a heteroarylene comprising 2 or 3 condensed rings; wherein $A^1$ is bonded to E via a direct bond between one of the condensed rings and E; and wherein $A^1$ is bonded to $A^2$ via a direct bond between one of the condensed rings and $A^2$;

- $A^2$ is selected from the group consisting of a substituted or unsubstituted carbocyclic aromatic ring, a substituted or unsubstituted heterocyclic aromatic ring, a substituted or unsubstituted condensed bicyclic aromatic system and a substituted or unsubstituted condesned bicyclic heteroaromatic system; wherein $A^2$ is bonded to $A^3$ via a direct bond between one of the aromatic or heteroaromatic rings and $A^3$; and

- $A^3$ is selected from the group consisting of a monocyclic aryl and a monocyclic heteroaryl, wherein $A^3$ is substituted with at least three groups independently selected from the group consisting of substituted or unsubstituted $C_6$-$C_{18}$ aryl and $C_2$-$C_{18}$ heteroaryl.

In Formula (II) E may be selected from the group consisting of pyrimidine, pyrazine, pyridazine, triazine, naphthalene and aza-analogs thereof, especially quinazoline, anthracene and aza-analogs thereof, phenanthrene and aza-analogs thereof, specially benzoquinazoline, fluorene and aza-analogs thereof, benzofluorene and aza-analogs thereof, dibenzofluorene and aza-analogs thereof, naphtofluorene and aza-analogs thereof, benzo-naphtofluorene and aza-analogs thereof, dinaphtofluorene and aza-analogs thereof, benzimidazole and aza analogs thereof, benzoxazole and aza analogs thereof, benzothiazole and aza analogs thereof, pyrido-imidazole and aza analogs thereof, benzofurane and aza-analogs thereof, benzothiophene and aza-analogs thereof, dibenzofurane and aza-analogs thereof, dibenzothiophene and aza-analogs thereof, naphtofurane and aza-analogs thereof, naphtothiophene and aza-analogs thereof, naphtobenzofurane and aza-analogs thereof, naphtobenzothiophene and aza-analogs thereof, dinaphtofurane and aza-analogs thereof, dinaphtothiophene and aza-analogs thereof, aryl consisting of 4, 5, 6 or 7 condensed rings and aza-analogs thereof, and heteroaryl consisting of 3, 4, 5, 6 or 7 condensed rings and comprising 1, 2 or 3 ring atoms independently selected from O and S, and aza-analogs of the heteroaryl consisting of 3, 4, 5, 6 or 7 condensed rings and comprising 1, 2 or 3 ring atoms independently selected from O and S, wherein the groups may be substituted or unsubstituted, respectively, especially with one or more phenyl and/or pyridyl groups, wherein the phenyl and/or pyridyl groups may be substituted or unsubstituted.

In one embodiment, E in Formula (II) may be selected from the group consisting of pyrimidine, pyrazine, cinnoline, quinoline, phtalazine, quinoxaline, quinazoline, benzoquinazoline, pyrido-imidazole, benzimidazole, pyridobenzimidazole and 1,3,5-triazine, wherein the groups may be substituted or unsubstituted, respectively, especially may be substituted with one or more unsubstituted phenyl.

In one embodiment, $A^1$ in Formula (II) may be selected from the group consisting of naphtalene-diyl and aza-analogs thereof, anthracene-diyl and aza-analogs thereof, phenanthrene-diyl and aza-analogs thereof, fluorene-diyl and aza-analogs thereof, benzothiophene-diyl and aza-analogs thereof, benzofurane-diyl and aza-analogs thereof, naphtofurane-diyl and aza-analogs thereof, naphtothiophene-diyl and aza-analogs thereof, dibenzofurane-diyl aza-analogs thereof, and dibenzothiophene-diyl and aza-analogs thereof.

In one embodiment, $A^1$ in Formula (II) may be selected from the group consisting of naphtalene-1,2-diyl, naphtalene-1,3-diyl, naphtalene-1,4-diyl, naphtalene-1,5-diyl, naphtalene-1,6-diyl, naphtalene-1,7-diyl, naphtalene-1,8-diyl, naphtalene-2,3-diyl, and naphtalene-2,6-diyl, naphtalene-2,7-diyl, and phenanthrene-9,10-diyl.

In one embodiment, $A^2$ in Formula (II) may be selected from the group consisting of phenylene, thiophenylene, furanylene, pyrazolylene, imidazolylene, triazolylene, pyridinylene, pyrimidinylene, pyridazinylene, pyrazinylene and triazinylene.

In one embodiment, $A^2$ in Formula (II) may be is selected from the group consisting of o-phenylene, m-phenylene, p-phenylene, and pyridine-3,5-ylene.

In one embodiment, $A^3$ in Formula (II) may be selected from the group consisting of phenyl, thiophenyl, furanyl, pyridinyl, pyrimidinyl, pyridazinyl, and pyrazinyl.

In one embodiment, $A^3$ in formula (II) may be selected from the group consisting of phenylene, pyridinyl,

pyrimidinyl and pyrazinyl.

In various embodiments, at least three groups by which $A^3$ in Formula (II) is substituted may be independently selected from the group consisting of unsubstituted phenyl, phenyl substituted with one or more hydrocarbyl groups, wherein the total number of carbon atoms in the phenyl substituted with one or more hydrocarbyl groups is from 7 to 18, pyridyl, pyridyl substituted with one or more hydrocarbyl groups, wherein the total number of carbon atoms in the phenyl substituted with one or more hydrocarbyl groups is from 7 to 18, and CN-substituted phenyl, especially phenyl substituted with one CN.

The first electron transport layer matrix compound may be selected from the following structures G1 to G28

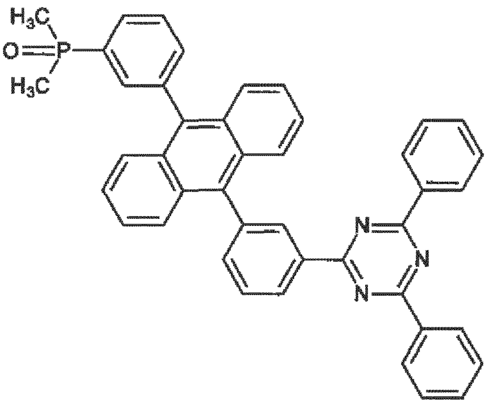

G1

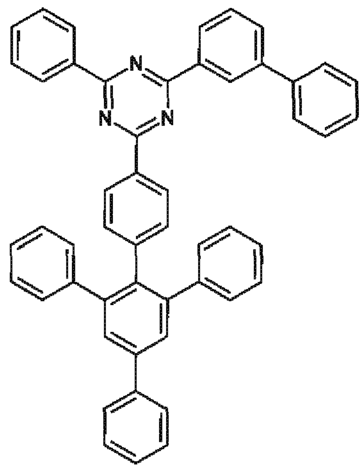

G2

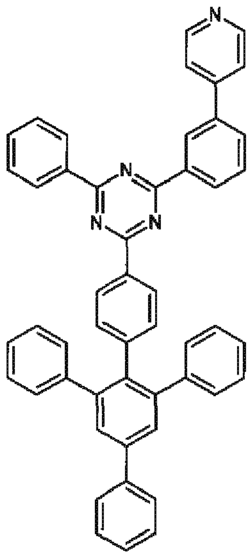

G3

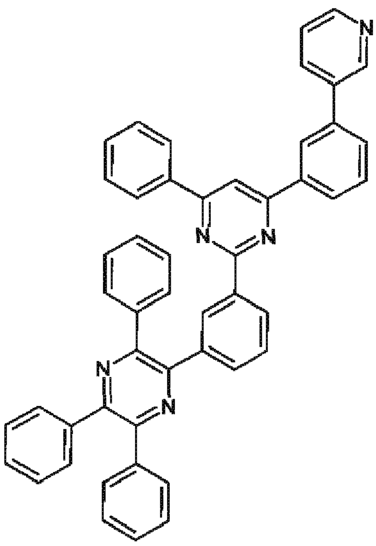

G4

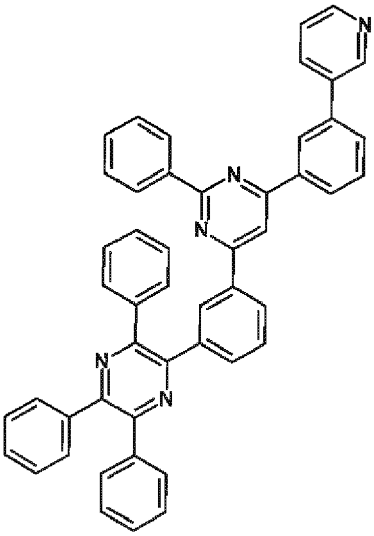

G5

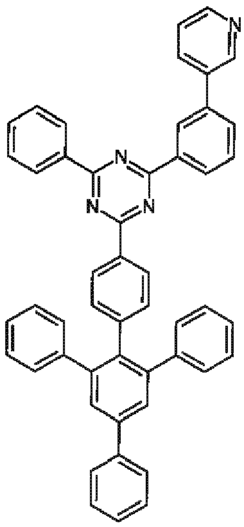

G6

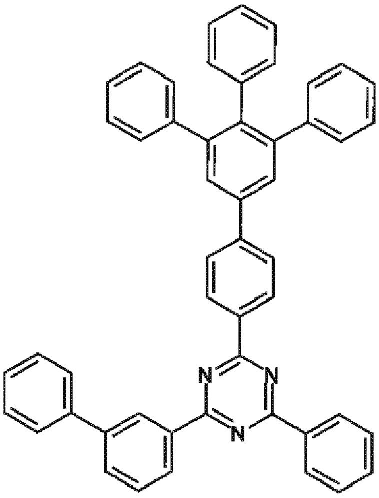

G7

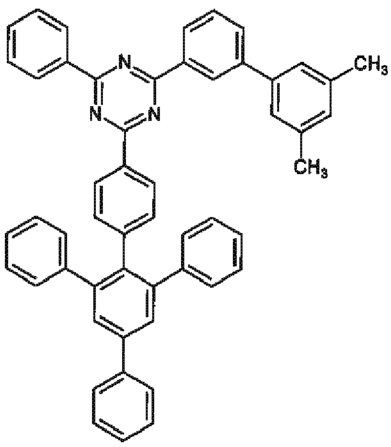

G8

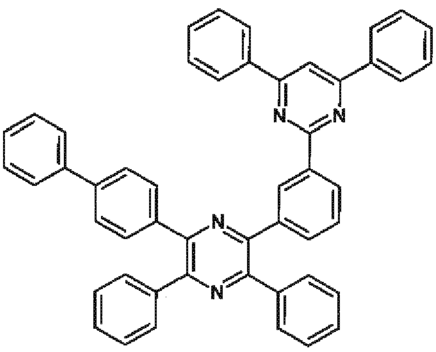

G9

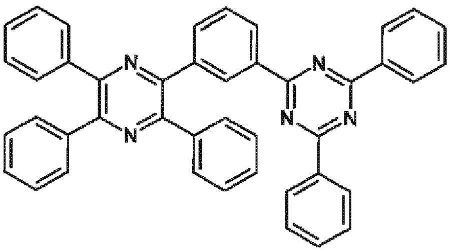

G10

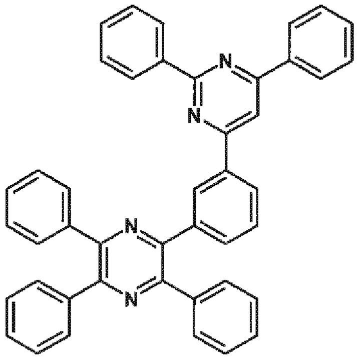

G11

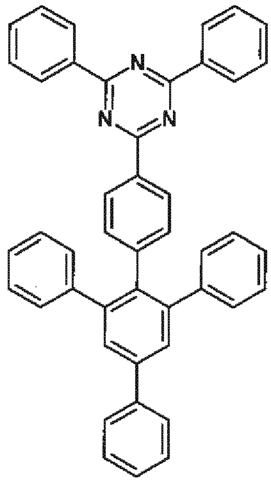

G12

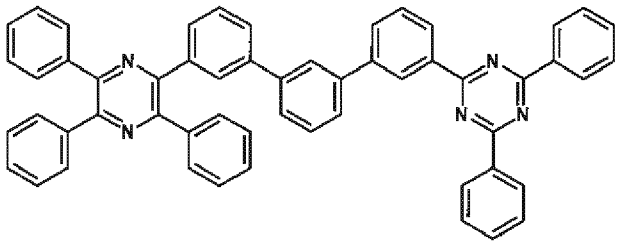

G13

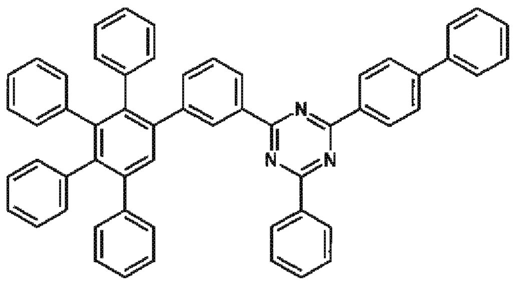

G14

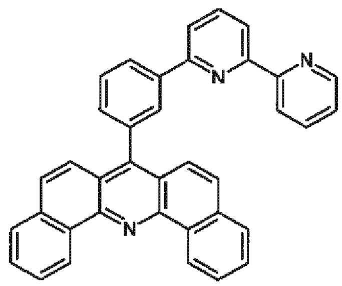

G15

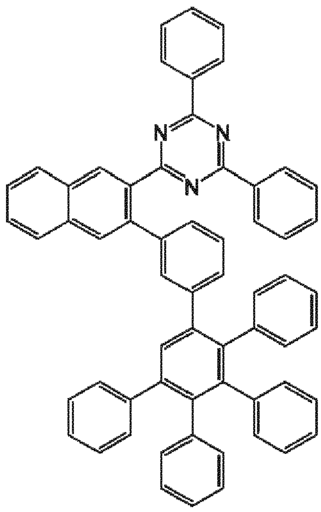

G16

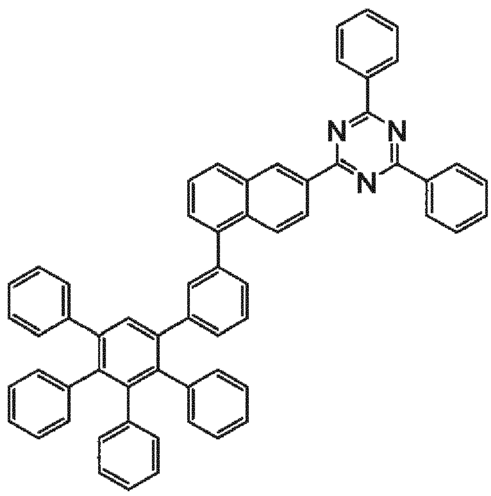

G17

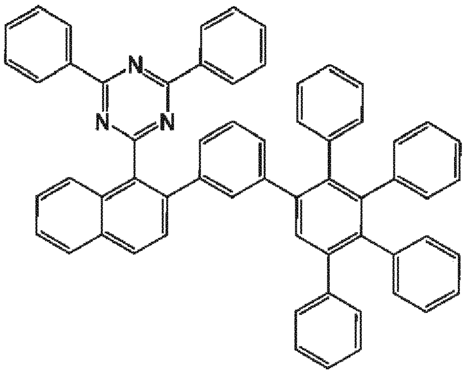

G18

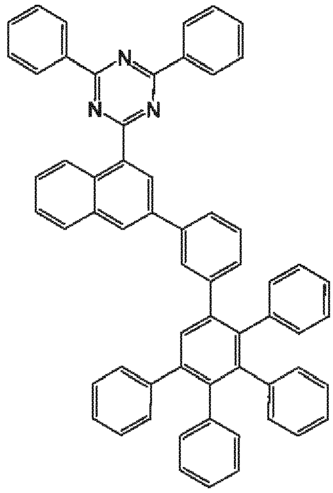

G19

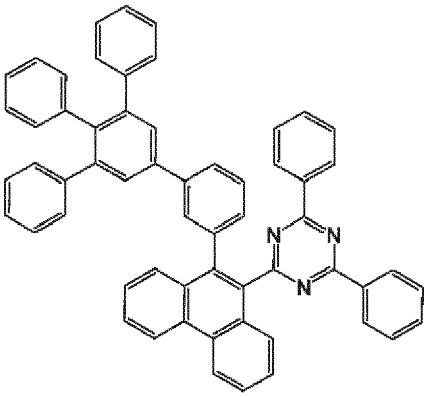

G20

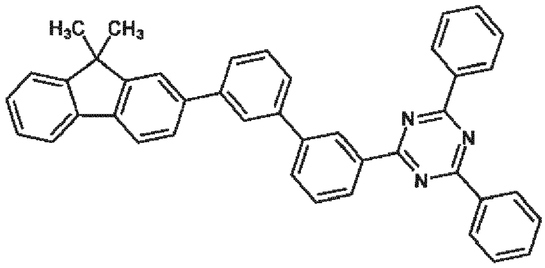

G21

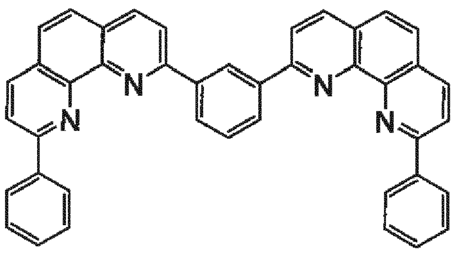

G22

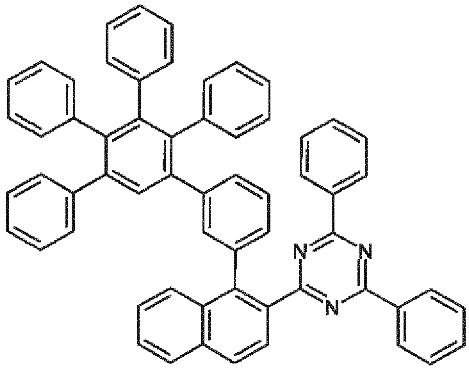

G23

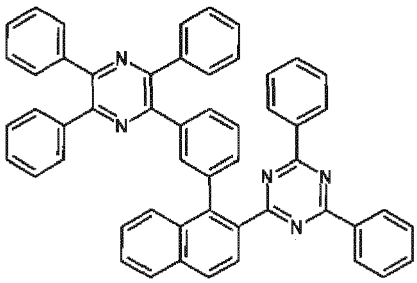

G24

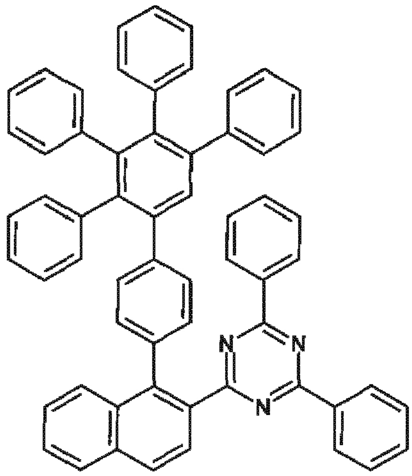

G25

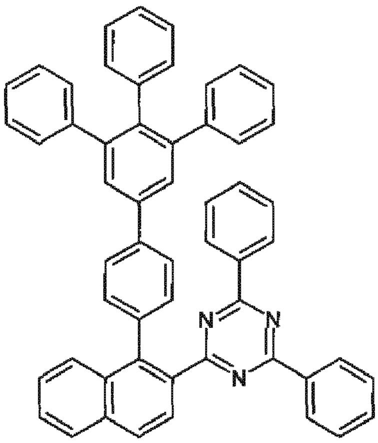

G26

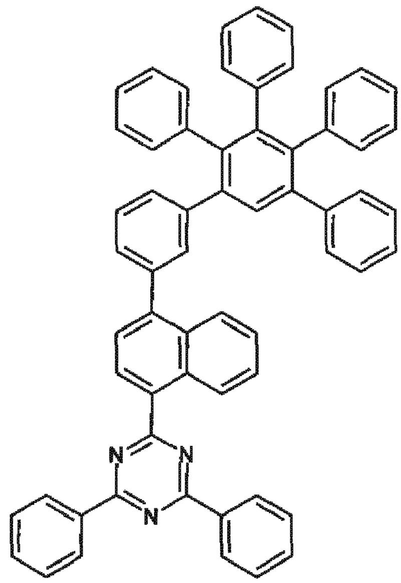

G27

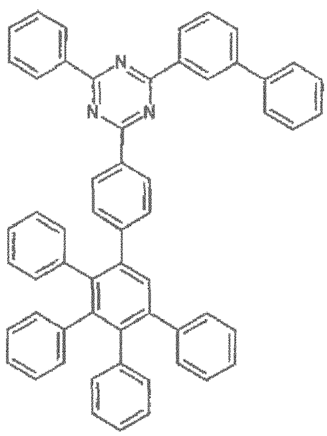

G28.

The first electron transport layer matrix material may comprise a first electron transport layer matrix compound and a second electron transport layer matrix compound. The first electron transport layer matrix compound and the second electron transport layer matrix compound are selected independently from each other. The second electron

transport layer matrix compound may be selected independently from one or more of the above embodiments defining the first electron transport layer matrix compound or combinations thereof.

Second electron transport layer

The organic light emitting device may further comprise a second electron transport layer. The second electron transport layer may be arranged between the second emission layer and the cathode. The second electron transport layer comprises a second electron transport material. The second emission layer is arranged closer to the cathode than the first emission layer.

The first electron transport material and the second electron transport material may comprise the same electron transport matrix compound or mixture of electron matrix compounds, especially one or more electron transport matrix compounds as defined above in one or more embodiments and combinations thereof for the first electron transport matrix compound.

The second electron transport layer may comprise an electrical dopant. In this regards, electrical dopants are in particular, but not limited thereto, electrical n-dopants. The electrical n-dopant may be selected from a metal, alternatively an alkali metal, a metal salt alternatively an alkaline earth metal salt and/or rare earth metal salt, or an organic alkali metal complex, alternatively an alkali metal complex, alternatively LiF, LiCl, LiBr, LiI, LiQ, a metal borate, or mixtures thereof. In particular, the first electron transport layer and the second electron transport layer may be free of an electrical n-dopant. The electrical n-dopant may be a metal salt comprising at least one metal cation and at least one anion. The metal cation of the metal salt may be selected from the group consisting of alkali metals, alkaline earth metals, and rare earth metals, alternatively from the group consisting of Li, Na, K, Rb, Cs, Mg, Ca, Sr, and Ba; alternatively from Li, Mg, Ca, and Sr. The anion of the metal salt may be selected from the group consisting of quinolinolate, phosphine oxide phenolate and borate. Especially, the electrical dopant may be LiQ.

In this regard, electrical n-dopants are in particular, but not limited thereto, an elemental metal, alternatively an electropositive metal selected from alkali metals, alkaline earth metals, rare earth metals and transition metals, transition metals; a metal salt, alternatively an alkali metal salt, alkaline earth metal salt and/or rare earth metal salt, or a metal complex, alternatively an alkali metal complex, alkaline earth metal complex, transition metal complex and/or rare earth metal complex. Examples of n-doping metal salts can be LiF, LiCl, LiBr, LiI, metal borates, metal quinolinolates or mixtures thereof. Further examples of electrical n-dopants are strong chemical reducing agents. This class of "redox" n-dopants may be generically characterized by energy level of the highest occupied molecular orbital (HOMO) comparable with lowest unoccupied molecular orbital Energy Level of corresponding electron transport matrices, which is in usual OLED transport materials about -3.0 eV or less. It is to be understood that the term "about -3.0 eV or less" means less negative values than -3.0 eV, for example -2.8 eV, -2.5 eV, -2.3 eV, -2.1 eV or vales less negative than -2.0 eV.

Electrical n-dopants may be organic compounds as disclosed in EP1837926A1, WO07107306A1 or WO07107356A1.

Electron injection layer

The organic light emitting device may further comprise an electron injection layer and the electron injection layer may be arranged between the second electron transport layer and the cathode.

The second electron transport layer may be in direct contact with the electron injection layer. The second electron transport layer may be in direct contact with the cathode. The electron injection layer may be contacting sandwiched between the second electron transport layer and the cathode.

The electron injection layer may comprise a metal, alternatively an alkali metal, a metal salt alternatively an alkaline earth metal salt and/or rare earth metal salt, or an organic alkali metal complex, alternatively an alkali metal complex, alternatively LiF, LiCl, LiBr, LiI, LiQ, a metal borate, or mixtures thereof. Especially, the electron injection layer may comprise Yb.

The electron injection layer may consist of a metal, alternatively an alkali metal, a metal salt alternatively an alkaline earth metal salt and/or rare earth metal salt, or an organic alkali metal complex, alternatively an alkali metal complex, alternatively LiF, LiCl, LiBr, LiI, LiQ, a metal borate, or mixtures thereof. Especially, the electron injection layer may consist of Yb.

Further layers

In accordance with the invention, the organic light emitting device may comprise, besides the layers already mentioned above, further layers. Exemplary embodiments of respective layers are described in the following:

*Substrate*

The substrate may be any substrate that is commonly used in manufacturing organic light emitting device. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

*Anode electrode*

Either the first electrode or the second electrode may be an anode electrode. The anode electrode may be formed by depositing or sputtering a material that is used to form the anode electrode. The material used to form the anode electrode may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode electrode may also be formed using metals, typically silver (Ag), gold (Au), or metal alloys.

*Hole injection layer*

The hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500°C, a pressure of $10^{-8}$ to $10^{-3}$ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

In such a case, the HIL may be a pure layer of p-dopant or may be selected from a holetransporting matrix compound doped with a p-dopant. Typical examples of known redox doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; $\alpha$-NPD (N,N'-Bis(naphthalen-1-yl)-N,N'-bis(phenyl)-benzidine) doped with F4TCNQ. $\alpha$-NPD doped with 2,2'-(perfluoronaphthalen-2,6-diylidene) dimalononitrile (PD1). $\alpha$-NPD doped with 2,2',2"-(cyclopropane-1,2,3-triylidene)tris(2-(p-cyanotetrafluorophenyl)acetonitrile) (PD2). Dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

*Hole transport layer*

The hole transport layer (HTL) maybe formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed by any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

*Electron blocking layer*

The function of the electron blocking layer (EBL) is to prevent electrons from being transferred from the emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

The electron blocking layer may comprise a compound of formula Z below (Z).

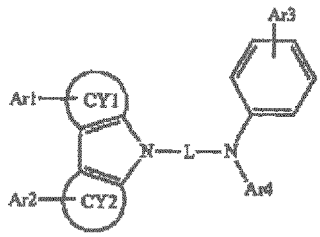

(Z).

In Formula Z, CY1 and CY2 are the same as or different from each other, and each independently represent a benzene cycle or a naphthalene cycle, Ar1 to Ar3 are the same as or different from each other, and each independently selected from the group consisting of hydrogen; a substituted or unsubstituted aryl group having 6 to 30 carbon atoms; and a substituted or unsubstituted heteroaryl group having 5 to 30 carbon atoms, Ar4 is selected from the group consisting of a substituted or unsubstituted phenyl group, a substituted or unsubstituted biphenyl group, a substituted or unsubstituted terphenyl group, a substituted or unsubstituted triphenylene group, and a substituted or unsubstituted heteroaryl group having 5 to 30 carbon atoms, L is a substituted or unsubstituted arylene group having 6 to 30 carbon atoms.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Emission layer (EML)*

The at least two EMLs may be formed independently on HTLs by vacuum deposition, spin coating, slot-die coat-ing, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The respective emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA), bis(2-(2-hydroxyphenyl)benzo-thiazolate)zinc ($Zn(BTZ)_2$), EML3 below, Compound 1 below, and Compound 2 below.

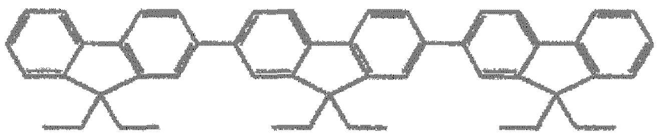

EML3

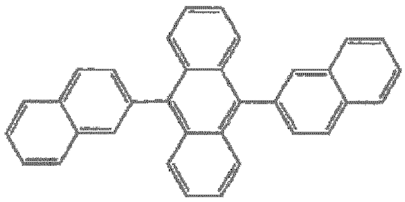

ADN

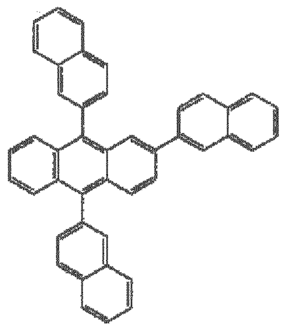

Compound 1

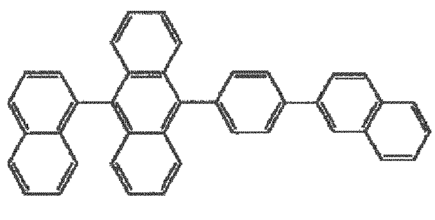

Compound 2

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, $Ir(piq)_3$, and $Btp_2Ir(acac)$, but are not limited thereto. These compounds are phosphorescent emitters, however, fluorescent red emitter dopants could also be used.

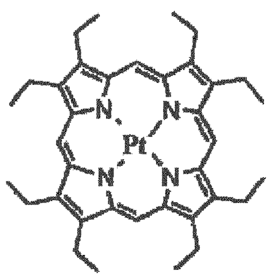

PtOEP

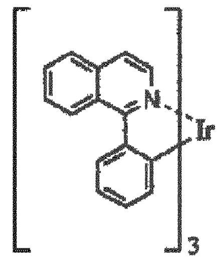

$Ir(piq)_3$

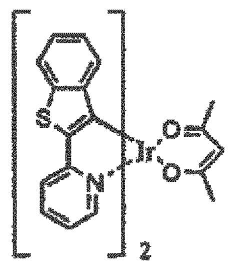

$Btp_2Ir(acac)$

Examples of phosphorescent green emitter dopants are $Ir(ppy)_3$ (ppy = phenylpyridine), $Ir(ppy)_2(acac)$, $Ir(mpyp)_3$ are shown below. Compound 3 is an example of a fluorescent green emitter and the structure is shown below.

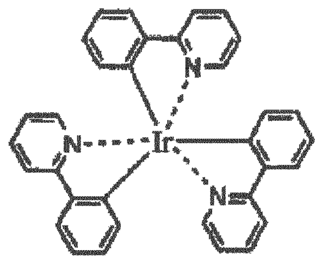

$Ir(ppy)_3$

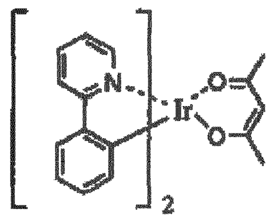

$Ir(ppy)_2(acac)$

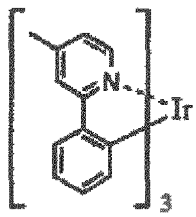

$Ir(mpyp)_3$

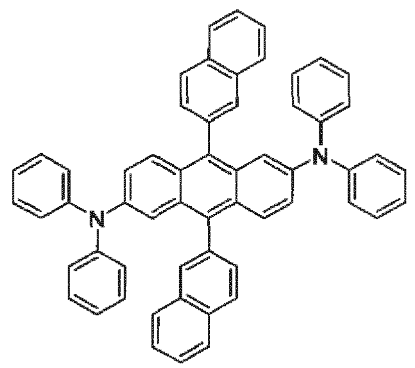

Compound 3

Examples of phosphorescent blue emitter dopants are F2Irpic, (F2ppy)2Ir(tmd) and $Ir(dfppz)_3$, ter-fluorene, the structures are shown below. 4.4'-bis(4-diphenyl amiostyryl)biphenyl (DPAVBi), 2,5,8,11-tetra-tert-butyl perylene (TBPe), and Compound 4 below are examples of fluorescent blue emitter dopants.

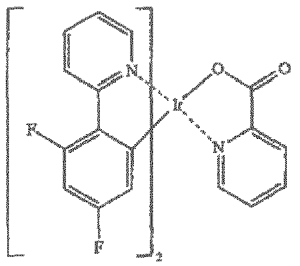
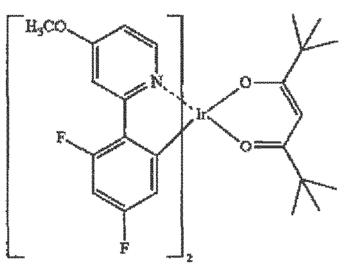
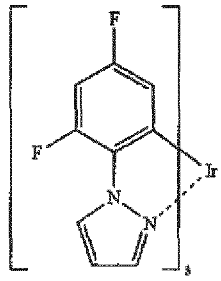

F2Irpic (F2ppy)2Ir(tmd) Ir(dfppz)3

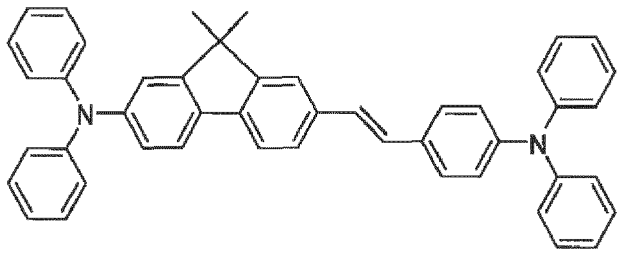

Compound 4

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

*Hole blocking layer (HBL)*

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, and phenanthroline derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

*Electron transport layer (ETL)*

The OLED according to the present invention may contain an electron transport layer (ETL).

According to various embodiments the OLED may comprise an electron transport layer or an electron transport layer stack comprising at least a first electron transport sub-layer and at least a second electron transport sub-layer.

By suitably adjusting energy levels of particular layers of the ETL, the injection and transport of the electrons may be controlled, and the holes may be efficiently blocked. Thus, the OLED may have long lifetime.

The electron transport layer of the organic light emitting device may comprise an organic electron transport matrix (ETM) material. Further, the electron transport layer may comprise one or more n-dopants. Suitable compounds for the ETM are not particularly limited. In one embodiment, the electron transport matrix compounds consist of covalently bound atoms. Preferably, the electron transport matrix compound comprises a conjugated system of at least 6, more preferably of at least 10 delocalized electrons. In one embodiment, the conjugated system of delocalized electrons may be comprised in aromatic or heteroaromatic structural moieties, as disclosed e.g. in documents EP 1 970 371 A1 or WO 2013/079217 A1.

In one embodiment, the electron transport layer may be electrically doped with an electrical n-dopant. In another embodiment, the electron transport layer may comprise the second electron transport sub-layer which is arranged closer

to the cathode than the first electron transport sub-layer and only the second electron transport sub-layer may comprise the electrical n-dopant.

The electrical n-dopant may be selected from electropositive elemental metals, and/or from metal salts and metal complexes of electropositive metals, particularly from elemental forms, salts and/or complexes of metal selected from alkali metals, alkaline earth metals, and rare earth metals.

*Electron injection layer (EIL)*

The optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, $Li_2O$, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

*Cathode electrode*

The cathode electrode is formed on the EIL if present. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO. The cathode may comprise more that 50 volume % of metal selected from Ag and Au.

The thickness of the cathode electrode may be in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy.

The cathode may be a semitransparent metal cathode having a thickness less than 20 nm, preferably less than 15 nm, even more preferably less than 12 nm.

It is to be understood that the cathode electrode is not part of an electron injection layer or the electron transport layer.

*Charge generation layer/hole generation layer*

The charge generation layer (CGL) is composed of a double layer.

The charge generation layer is a pn junction joining an n-type charge generation layer (electron generation layer) and a p-type charge generation layer (hole generation layer). The n-side of the pn junction generates electrons and injects them into the layer which is adjacent in the direction to the anode. Analogously, the p-side of the p-n junction generates holes and injects them into the layer which is adjacent in the direction to the cathode.

Charge generation layers are used in tandem devices, for example, in tandem OLEDs comprising, between two electrodes, two or more emission layers. In a tandem OLED comprising two emission layers, the n-type charge generation layer provides electrons for the first light emission layer arranged near the anode, while the p-type charge generation layer provides holes to the second light emission layer arranged between the first emission layer and the cathode.

The hole generation layer can be composed of an organic matrix material doped with p-type dopant. Suitable matrix materials for the hole generation layer may be materials conventionally used as hole injection and/or hole transport matrix materials. Also, p-type dopant used for the hole generation layer can employ conventional materials. For example, the p-type dopant can be one selected from a group consisting of tetrafluore-7,7,8,8-tetracyanoquinodimethane ($F_4$-TCNQ), derivatives of tetracyanoquinodimethane, radialene derivatives, iodine, $FeCl_3$, $FeF_3$, and $SbCl_5$. Also, the host can be one selected from a group consisting of N,N'-di(naphthalen-i-yl)-N,N-diphenyl-benzidine (NPB), N,N'-diphenyl-N,N'-bis(3-methylphenyl)-1,1-biphenyl-4,4'-diamine (TPD) and N,N',N'-tetranaphthyl-benzidine (TNB).

In accordance with the invention, at least one n-type charge generation layer comprised in the inventive organic light emitting device is the n-type sub-layer defined herein. In case that the organic light emitting device comprises more than one n-type charge generation layers (= n-type sub-layer), it is only provided that at least one of these n-type charge generation layers is as defined therein.

In a preferred embodiment, n-type charge generation layer comprises of a) a first organic compound b) a second

organic compound and c) a zero-valent metal dopant, wherein the zero-valent metal dopant is a metal selected from the group consisting of alkali metals, alkaline earth metals, rare earth metals, group 3 transition metals and mixtures thereof. Alternatively comprising of a) the first organic compound, wherein the first organic compound is a compound comprising at least one P=X group, wherein X is selected from O, S or Se; b) the second organic compound, and the second organic compound comprises at least one metal complexing group, alternatively two metal complexing groups and c) a zero-valent metal dopant, wherein the zero-valent metal dopant is a metal selected from the group consisting of alkali metals, alkaline earth metals, rare earth metals, group 3 transition metals and mixtures thereof.

In a preferred embodiment, n-type charge generation layer consisting of, a) a first organic compound b) a second organic compound and c) a zero-valent metal dopant, wherein the zero-valent metal dopant is a metal selected from the group consisting of alkali metals, alkaline earth metals, rare earth metals, group 3 transition metals and mixtures thereof. Alternatively consisting of a) the first organic compound, wherein the first organic compound is a compound comprising at least one P=X group, wherein X is selected from O, S or Se; b) the second organic compound, and the second organic compound comprises at least one metal complexing group, alternatively two metal complexing groups and c) a zero-valent metal dopant, wherein the zero-valent metal dopant is a metal selected from the group consisting of alkali metals, alkaline earth metals, rare earth metals, group 3 transition metals and mixtures thereof.

In a preferred embodiment, n-type charge generation layer may comprises the first organic compound and the second organic compound in a wt.-% ratio from 05:95 to 50:50, 10:90 to 50:50, 20:80 to 50:50 or 30:70 to 50:50 preferably 10:90 to 50:50, 20:80 to 50:50 or 30:70 to 50:50.

In a preferred embodiment, n-type charge generation layer may comprises the first organic compound and the second organic compound in a wt.-% ratio from 95:05 to 50:50, 90:10 to 50:50, 80:20 to 50:50 or 70:30 to 50:50 preferably 90:10 to 50:50, 80:20 to 50:50 or 70:30 to 50:50.

Alternatively, it can be provided that other n-type charge generation layers (besides the at least one) are formed differently. If the n-type charge generation layer is not a n-type sub-layer as defined therein, the n-type charge generation layer can be layer of a neat n-dopant, for example of an electropositive metal, or can consist of an organic matrix material doped with the n-dopant. In one embodiment, the n-type dopant can be alkali metal, alkali metal compound, alkaline earth metal, or alkaline earth metal compound. In another embodiment, the metal can be one selected from a group consisting of Li, Na, K, Rb, Cs, Mg, Ca, Sr, Ba, La, Ce, Sm, Eu, Tb, Dy, and Yb. More specifically, the n-type dopant can be one selected from a group consisting of Cs, K, Rb, Mg, Na, Ca, Sr, Eu and Yb. Suitable matrix materials for the electron generating layer may be the materials conventionally used as matrix materials for electron injection or electron transport layers. The matrix material can be for example one selected from a group consisting of triazine compounds, hydroxyquinoline derivatives like tris(8-hydroxyquinoline)aluminum, benzazole derivatives, and silole derivatives.

In one embodiment, the p-type charge generation layer may include compounds of the following Chemical Formula X.

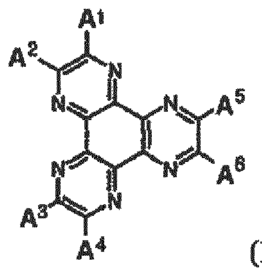

(X),

wherein each ofA1 to A6 may be hydrogen, a halogen atom, nitrile (-CN), nitro (-NO2), sulfonyl (-SO2R), sulfoxide (-SOR), sulfonamide (-SO2NR), sulfonate (-SO3R), trifluoromethyl (-CF3), ester (-COOR), amide (-CONHR or -CONRR'), substituted or unsubstituted straight-chain or branched-chain C1-C12 alkoxy, substituted or unsubstituted straight-chain or branched-chain C1-C12 alkyl, substituted or unsubstituted straight-chain or branched chain C2-C12 alkenyl, a substituted or unsubstituted aromatic or non-aromatic heteroring, substituted or unsubstituted aryl, substituted or unsubstituted mono- or di-arylamine, substituted or unsubstituted aralkylamine, or the like. Herein, each of the above R and R' may be substituted or unsubstituted C1-C60 alkyl, substituted or unsubstituted aryl, or a substituted or unsubstituted 5- to 7-membered heteroring, or the like.

An example of such p-type charge generation layer may be a layer comprising CNHAT

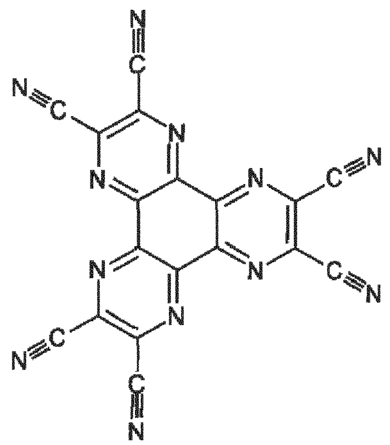

(CNHAT).

The hole generating layer may be arranged on top of the n-type charge generation layer.

With regard to the method for producing the organic electronic device, the alternative embodiments outlined above may be applied mutatis mutandis. For example, the charge generation layer may be produced with an interlayer provided between the n-type sub-layer, and the p-type sub-layer.

*Organic light-emitting diode (OLED)*

According to one aspect, the OLED according to the present invention can comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer (n-type sub-layer), the n-type charge generation layer is adjacent arranged to a hole generating layer (p-type sub-layer), an interlayer may be provided between the n-type sub-layer, and the p-type sub-layer, the hole generating layer is adjacent arranged to a second hole transport layer, the second hole transport layer is adjacent arranged to a second electron blocking layer, the second electron blocking layer is adjacent arranged to a second emission layer, between the second emission layer and the cathode electrode an optional electron transport layer and/or an optional injection layer are arranged.

The stack of layers may be produced by techniques known in the art as such. For example, one or more layers in the stack may be produced by vacuum thermal evaporation.

With regard to the method of producing the organic electronic device, the depositing of the plurality of layers may comprise a step of depositing the p-type sub-layer, the depositing comprising evaporation and deposition of the fullerene compound in vacuum. Preferably, all layers are deposited in vacuum.

Details and Definitions of the invention

An organic compound as referred to herein is generally any chemical compound that contains carbon (except some compounds generally referred to as being inorganic, such as carbonates, cyanides, carbon dioxide, diamond etc.). The term organic compound used herein also encompasses compounds such as organometallic compounds, for example metallocenes etc.

The term "zero-valent" as used herein refers to a metal in the oxidation state o, i.e. particular to metals from which no electron has been removed. The zero-valent metal may be present in the form of zero-valent atoms, neat metal, alloys etc.

The term "trivalent" as used herein refers to a nitrogen atom with a single bond and a double bond and containing a lone pair of electrons.

The term "metal complexing group" as used herein refers to a group which can form a bond with a metal ion.

The term "hydrocarbyl group" as used herein shall be understood to encompass any organic group comprising carbon atoms, in particular organic groups, such as alkyl, aryl, heteroaryl, heteroalkyl, in particular such groups which are substituents usual in organic electronics.

The term "conjugated system" as used herein refer to a system of alternating $\pi$- and $\sigma$-bonds or a molecule having alternating single and multiple bonds i.e. double bond or a system having one or more two-atom structural units having the $\pi$-bond between its atoms can be replaced by an atom bearing at least one lone electron pair, typically by a

divalent O or S atom.

The term "alkyl" as used herein shall encompass linear as well as branched and cyclic alkyl. For example, C3-alkyl may be selected from n-propyl and iso-propyl. Likewise, C4-alkyl encompasses n-butyl, sec-butyl and t-butyl. Likewise, C6-alkyl encompasses n-hexyl and cyclohexyl.

The subscribed number n in Cn relates to the total number of carbon atoms in the respective alkyl, arylene, heteroarylene or aryl group.

The term "aryl" as used herein shall encompass phenyl (C6-aryl), fused aromatics, such as naphthalene, anthracene, phenanthrene, tetracene etc. Further encompassed are biphenyl and oligo- or polyphenyls, such as terphenyl etc. Further encompassed shall be any further aromatic hydrocarbon substituents, such as fluorenyl etc. Arylene, respectively heteroarylene refers to groups to which two further moieties are attached.

The term "heteroaryl" as used herein refers to aryl groups in which at least one carbon atom is substituted by a heteroatom, preferably selected from N, O, S, B or Si.

The term "halogenated" refers to an organic compound in which one hydrogen atom thereof is replaced by a halogen atom. The term "perhalogenated" refers to an organic compound in which all of the hydrogen atoms thereof are replaced by halogen atoms. The meaning of the terms "fluorinated" and "perfluorinated" should be understood analogously.

The subscripted number n in Cn-heteroaryl merely refers to the number of carbon atoms excluding the number of heteroatoms. In this context, it is clear that a C3 heteroarylene group is an aromatic compound comprising three carbon atoms, such as pyrazol, imidazole, oxazole, thiazole and the like.

In terms of the invention, the expression "between" with respect to one layer being between two other layers does not exclude the presence of further layers which may be arranged between the one layer and one of the two other layers. In terms of the invention, the expression "in direct contact" with respect to two layers being in direct contact with each other means that no further layer is arranged between those two layers. One layer deposited on the top of another layer is deemed to be in direct contact with this layer.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about $\geq$ 380 nm to about $\leq$ 780 nm.

With respect to the inventive organic light emitting device, the compounds mentioned in the experimental part may be most preferred.

The organic electroluminescent device (OLED) may be a bottom- or top-emission device.

Another aspect is directed to a device comprising at least one organic electroluminescent device (OLED). A device comprising organic light-emitting diodes is for example a display or a lighting panel.

In the present invention, the following defined terms, these definitions shall be applied, unless a different definition is given in the claims or elsewhere in this specification.

In the context of the present specification the term "different" or "differs" in connection with the matrix material means that the matrix material differs in their structural formula.

The energy levels of the highest occupied molecular orbital, also named HOMO, and of the lowest unoccupied molecular orbital, also named LUMO, are measured in electron volt (eV).

The terms "OLED" and "organic light-emitting diode" are simultaneously used and have the same meaning. The term "organic electroluminescent device" as used herein may comprise both organic light emitting diodes as well as organic light emitting transistors (OLETs).

As used herein, "weight percent", "wt.-%", wt%, "percent by weight", "% by weight", and variations thereof refer to a composition, component, substance or agent as the weight of that component, substance or agent of the respective electron transport layer divided by the total weight of the respective electron transport layer thereof and multiplied by 100. It is understood that the total weight percent amount of all components, substances and agents of the respective electron transport layer and electron injection layer are selected such that it does not exceed 100 wt.-%.

As used herein, "volume percent", "vol.-%", "percent by volume", "% by volume", and variations thereof refer to a composition, component, substance or agent as the volume of that component, substance or agent of the respective electron transport layer divided by the total volume of the respective electron transport layer thereof and multiplied by 100. It is understood that the total volume percent amount of all components, substances and agents of the cathode layer are selected such that it does not exceed 100 vol.-%.

All numeric values are herein assumed to be modified by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "free of", "does not contain", "does not comprise" does not exclude impurities. Impurities have no

technical effect with respect to the object achieved by the present invention.

BRIEF DESCRIPTION OF THE DRAWINGS

These and/or other aspects and advantages of the present invention will become apparent and more readily appreciated from the following description of the exemplary embodiments, taken in conjunction with the accompanying drawings, of which:

Fig. 1 is a schematic representation of a layer stack of a tandem organic light emitting diode device;

Fig. 2 is schematic representations of a layer stack of another tandem organic light emitting diode device;

Fig. 3 is a schematic representation of a layer stack of a further tandem organic light emitting diode device.

DETAILED DESCRIPTION

Reference will now be made in detail to the exemplary embodiments of the present invention, examples of which are illustrated in the accompanying drawings, wherein like reference numerals refer to the like elements throughout. The exemplary embodiments are described below, in order to explain the aspects of the present invention, by referring to the figures.

Herein, when a first element is referred to as being formed or disposed "on" a second element, the first element can be disposed directly on the second element or one or more other elements may be disposed there between. When a first element is referred to as being formed or disposed "directly on" a second element, no other elements are disposed there between.

In Fig. 1, a first hole injection layer 6, a first hole transport layer 7, and a first electron blocking layer 8 are provided between the anode 3 and a first emitting layer 9. A first electron transport layer 10 is provided between the first emitting layer 9 and the charge generation layer 5 (n-type sublayer 5a and p-type sublayer 5b). A second hole injection layer 11, second hole transport layer 12, and second electron blocking layer 13 are provided between the charge generation layer 5 and a second emitting layer 14. A second electron transport layer 15 is provided between the second emitting layer 14 and the cathode 4.

Fig. 2 shows a schematic representation of another tandem OLED. The stack of layers 1 provided on the substrate 2, in addition, comprises an interlayer 16 between n-type sublayer 5a and p-type sublayer 5b.

Fig. 3 shows a schematic representation of a further tandem OLED. In the stack of layers 1 provided on the substrate 2 the n-type sublayer 5a of the charge generation layer 5 comprises a first n-type sublayer 5a1 and a second n-type sublayer 5a2. In an alternative embodiment (not shown), the charge generation layer 5 of the tandem OLED in Fig. 5 may comprise the interlayer 16.

Hereinafter, one or more exemplary embodiments of the present invention will be described in detail with, reference to the following examples. However, these examples are not intended to limit the purpose and scope of the one or more exemplary embodiments of the present invention.

Dipole moment

The dipole moment $|\vec{\mu}|$ of a molecule containing N atoms is given by:

$$\vec{\mu} = \sum_{i}^{N} q_i \vec{r_i}$$

$$|\vec{\mu}| = \sqrt{\mu_x^2 + \mu_y^2 + \mu_z^2}$$

where $q_i$ and $\vec{r_i}$ are the partial charge and position of atom i in the molecule.

The dipole moment is determined by a semi-empirical molecular orbital method.

The geometries of the molecular structures are optimized using the hybrid functional B3LYP with the 6-31G* basis set in the gas phase as implemented in the program package TURBOMOLE V6.5 (TURBOMOLE GmbH, Litzenhardtstrasse 19, 76135 Karlsruhe, Germany). If more than one conformation is viable, the conformation with the lowest total energy is selected to determine the bond lengths of the molecules.

Calculated HOMO and LUMO

The HOMO and LUMO are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

Melting point

The melting point (mp) is determined as peak temperatures from the DSC curves of the above TGA-DSC measurement or from separate DSC measurements (Mettler Toledo DSC822e, heating of samples from room temperature to completeness of melting with heating rate 10 K/min under a stream of pure nitrogen. Sample amounts of 4 to 6 mg are placed in a 40 μL Mettler Toledo aluminum pan with lid, a <1 mm hole is pierced into the lid).

Glass transition temperature

The glass transition temperature (Tg) is measured under nitrogen and using a heating rate of 10 K per min in a Mettler Toledo DSC 822e differential scanning calorimeter as described in DIN EN ISO 11357, published in March 2010.

Rate onset temperature

The rate onset temperature (TRO) is determined by loading 100 mg compound into a VTE source. As VTE source a point source for organic materials may be used as supplied by Kurt J. Lesker Company (www.lesker.com) or CreaPhys GmbH (http://www.creaphys.com). The VTE source is heated at a constant rate of 15 K/min at a pressure of less than 10-5 mbar and the temperature inside the source measured with a thermocouple. Evaporation of the compound is detected with a QCM detector which detects deposition of the compound on the quartz crystal of the detector. The deposition rate on the quartz crystal is measured in Angstrom per second. To determine the rate onset temperature, the deposition rate is plotted against the VTE source temperature. The rate onset is the temperature at which noticeable deposition on the QCM detector occurs. For accurate results, the VTE source is heated and cooled three time and only results from the second and third run are used to determine the rate onset temperature.

To achieve good control over the evaporation rate of an organic compound, the rate onset temperature may be in the range of 200 to 255 °C. If the rate onset temperature is below 200 °C the evaporation may be too rapid and therefore difficult to control. If the rate onset temperature is above 255 °C the evaporation rate may be too low which may result in low tact time and decomposition of the organic compound in VTE source may occur due to prolonged exposure to elevated temperatures.

The rate onset temperature is an indirect measure of the volatility of a compound. The higher the rate onset temperature the lower is the volatility of a compound.

Reduction potential

The reduction potential is determined by cyclic voltammetry with potenioststic device Metrohm PGSTAT30 and software Metrohm Autolab GPES at room temperature. The redox potentials given at particular compounds were measured in an argon de-aerated, dry 0.1M THF solution of the tested substance, under argon atmosphere, with 0.1M tetrabutylammonium hexafluorophosphate supporting electrolyte, between platinum working electrodes and with an Ag/AgCl pseudo-standard electrode (Metrohm Silver rod electrode), consisting of a silver wire covered by silver chloride and immersed directly in the measured solution, with the scan rate 100 mV/s. The first run was done in the broadest range of the potential set on the working electrodes, and the range was then adjusted within subsequent runs appropriately. The final three runs were done with the addition of ferrocene (in 0.1M concentration) as the standard. The average of potentials corresponding to cathodic and anodic peak of the studied compound, after subtraction of the average of cathodic and anodic potentials observed for the standard Fc+/Fc redox couple, afforded finally the values reported above. All studied compounds as well as the reported comparative compounds showed well-defined reversible electrochemical behaviour.

Measurement of OLED Performance

To assess the performance of the OLED devices, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between oV and 10V. Likewise, the luminance-voltage characteristics and CIE coordinates are determined by measuring the luminance in cd/$m^2$ using an Instrument Systems CAS-140CT array spectrometer (calibrated by Deutsche Akkreditierungsstelle (DAkkS)) for each of the voltage values. The cd/A efficiency at 10 mA/$cm^2$ is determined by interpolating the luminance-voltage and current-voltage characteristics, respectively.
As applicable, Lifetime LT of the device can be measured at ambient conditions (20°C) and 30 mA/$cm^2$, using a Keithley 2400 sourcemeter, and recorded in hours.
The brightness of the device is measured using a calibrated photo diode. The lifetime LT is defined as the time till the brightness of the device is reduced to 97 % of its initial value.

Voltage stability

OLEDs are driven by constant current circuits. Those circuits can supply a constant current over a given voltage range. The wider the voltage range, the wider the power losses of such devices. Hence, the change of driving voltage upon driving needs to be minimized.
The driving voltage of an OLED is temperature dependent. Therefore, voltage stability needs to be judged in thermal equilibrium. Thermal equilibrium is reached after one hour of driving.
Voltage stability is measured by taking the difference of the driving voltage after 50 hours and after 1 hour driving at a constant current density. Here, a current density of 30 mA/$cm^2$ is used. Measurements are done at room temperature.

$$dU\,[V] = U(50\text{ h}, 30\text{ mA/cm}^2) - U(1\text{ h}, 30\text{ mA/cm}^2)$$

General synthesis procedure

A flask was flushed with nitrogen and charged with both starting materials in a 1:1 ratio or similar. The organic solvent was added and the mixture was deaerated. A second flask was charged with the base and water and was deaerated as well. The aqueous base was added to the starting materials under nitrogen and the reaction was started by the addition of the catalyst. The reaction mixture was heated to the given temperature until TLC showed full conversion. The mixture was then cooled to room temperature and the product was purified according to the methods given in the table. Each solid fraction obtained along the purification was subjected to drying under reduced pressure in an oven. The educts, synthesis details and yields for the new compounds are reported in Table 1.
Acronyms and abbreviations for chemicals and methods used throughout experimental part

| | |
|---|---|
| CAS | Chemical Abstract Service registry number |
| DCM | dichloromethane |
| EtOH | ethanol |
| Hex. | n-hexane |
| MeOH | methanol |
| THF | tetrahydrofuran |
| VTE | vacuum thermal evaporation |
| LC/MS | liquid chromatography / mass spectrometry |

**Table 1**

| compd | analogous syntheses | Educt 1 | Educt 2 | catalyst & solvent | work-up & purification | LC/MS |
|---|---|---|---|---|---|---|
| G3 | WO2021/ 069595 | 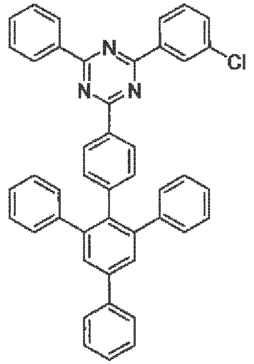 2437303-47-2 | 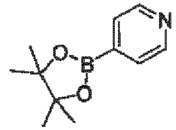 181219-01-2 | Pd [1798781-99-3], K2CO3, dioxane/water 4/1, 55°C | crude filtered off and washed with water, MeOH. The compound is purified by silica gel chromatography (CHCl3) multiple times. Yield 26% (10.7 g) | m/z = 691 [M+H] |
| G2 | WO2019/ 121 672 | 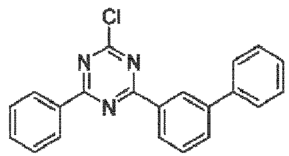 1689576-03-1 | 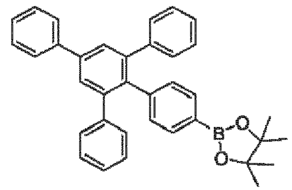 2576432-67-0 | Pd(PPh3)4, K2C03 dioxane/ water 4/1 85°C | crude filtered off and washed with water, MeOH, ethyl acetate. Then dissolved in CHCl3 and filtered through florisil. Solution evaporated and solid recrystallized from toluene. Yield 33% (22 g) | m/z = 690 [M+H] |
| G7 | WO2021/ 069595 | 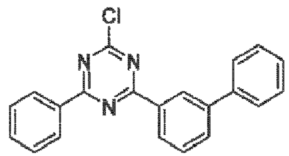 1689576-03-1 | 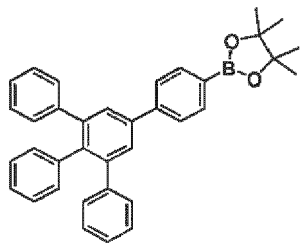 2358709-40-5 | Pd(PPh3)4, K2C03 toluene/THF/ water 4/1/1 90°C | crude filtered off and washed with toluene/THF, water and MeOH. Soxhlett extraction with toluene, crop after cooling is recrystallized from toluene, and another Soxhlett extraction of the solid with toluene performed. Solution is cooled and filtered off. Yield 67% (20 g) | m/z = 690 [M+H] |

(continued)

| compd | analogous syntheses | Educt 1 | Educt 2 | catalyst & solvent | work-up & purification | LC/MS |
|---|---|---|---|---|---|---|
| G4 | WO2021/ 009206 | 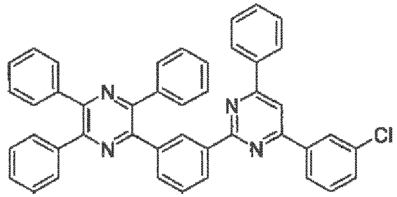 no CAS | 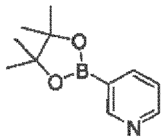 329214-79-1 | Pd [1798781-99-3], K3PO4, toluene/THF/ water 8/1/1, 75°C | crude is filtered off. Repeated column chromatography on silica gel using gradient eluent (CHCl3/Hex, CHCl3, CHCl3/MeOH). Selected fractions concentrated and solid precipitated with hexane. Precipitation is repeated 2 times from DCM/hexane. In the last cycle the DCM solution is treated with Florisil and filtered before hexane added. Yield 64% (15 g) | m/z = 692 [M+H] |
| G5 | WO2021/ 009206 | 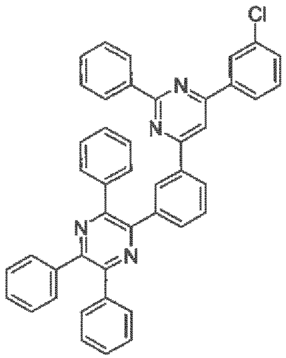 2586117-48-6 | 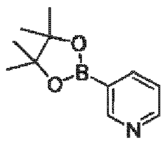 329214-79-1 | Pd [1798781-99-3], K3PO4, THF/ EtOH/water 10/1/5, rflx | crude filtered off and washed with water and MeOH [first crop]. A second crop is obtained from evaporation of the mother liquor and water/MeOH washing. The first crop is then recrystallized from THF and combined with the 2nd crop. Purification by silica gel chromatography. Yield 43% (11 g) | m/z = 692 [M+H]. m/z = 1383 [2M+H] |

(continued)

| compd | analogous syntheses | Educt 1 | Educt 2 | catalyst & solvent | work-up & purification | LC/MS |
|---|---|---|---|---|---|---|
| G9 | WO2019/ 238858 | 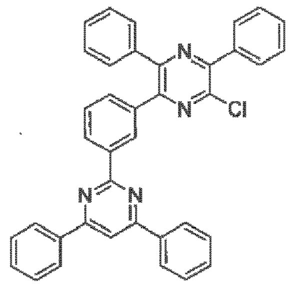 no CAS | 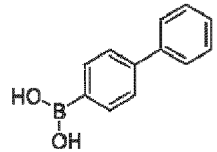 5122-94-1 | Pd(dppf)Cl2, K2CO3, dioxane/water 4/1, 70°C | reaction diluted with THF and filtered off, washed with dioxane. Crop was dissolved in DCM and washed with water, dried over Na2S04, filtered through Florisil followed by evaporation. Solid is recrystallized from toluene/ EtOH and the obtained solid then treated in hot THF. Solid is filtered off and washed with THF. Yield 69% (15 g) | m/z = 691 [M+H]. m/z = 1381 [2M+H] |
| G10 | WO2019/ 238858 | 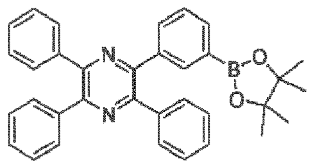 2396743-64-7 | 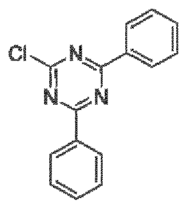 3842-55-5 | Pd(dppf)Cl2, K2CO3, dioxane/water 4/1, 60°C | crude filtered off and washed with dioxane, MeOH and water. Dissolved in CHCl3 and chromatographed on silica gel pad. Evaporated, precipitated and filtered. Yield 83% (21 g) | m/z = 616 [M+H] |
| G11 | WO2019/ 238858 | 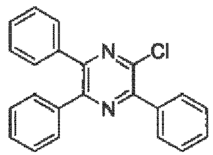 243472-78-8 | 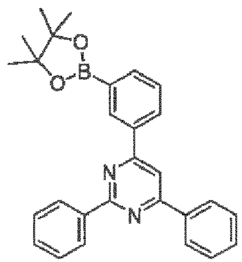 1342892-16-3 | Pd(PPh3)4, K2CO3 Dioxane/ water 4/1 80°C | crude filtered off and washed with dioxane and water. Dissolved in DCM and filtered through a Florisil pad. Evaporated and recrystallized from toluene. Yield 62% (12 g) | m/z = 615 [M+H] |

(continued)

| compd | analogous syntheses | Educt 1 | Educt 2 | catalyst & solvent | work-up & purification | LC/MS |
|---|---|---|---|---|---|---|
| E2 | WO2021/ 105518 | 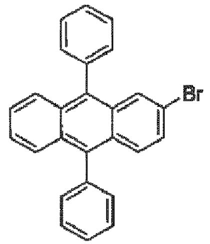 201731-79-5 | 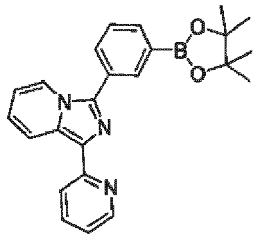 2646631-69-6 | Pd [1798781-99-3], K3PO4, THF/ water 7/1, RT to 60°C | separate phases, evaporate organic solvent. Dissolve in CHCl3 and wash with water. Then filter through silica gel (hot), evaporate and exchange to DCM/hexane 1/9. filter off and treat hot in acetone. The residue is dissolved in CHCl3 then concentrated and precipitated by adding acetone. Dissolving and precipitation with acetone from DCM repeated. Yield 65% (38 g) | m/z = 600 [M+H] |

Preparation of exemplary compounds of formula (II)

**2,4-diphenyl-6-(1-(3',4',5' -triphenyl-[1,1':2',1" -terphenyl]-3-yl)naphthalen-2-yl)-1,3,5-triazine (G23)**

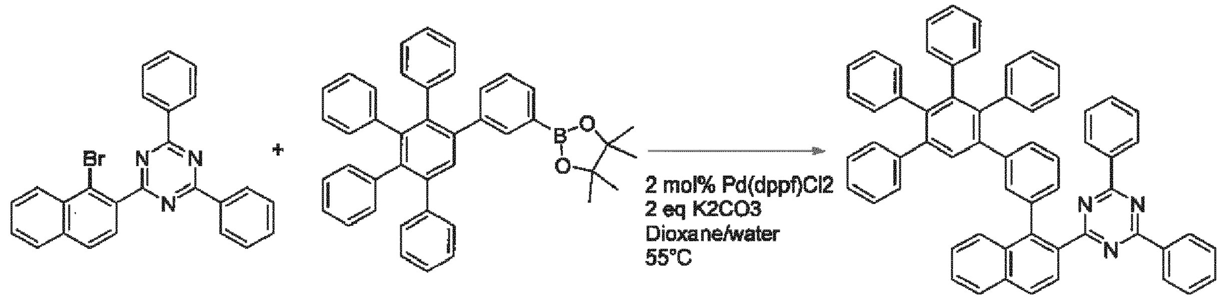


3-neck round-bottom flask was flushed with nitrogen and charged with 2-(1-bromonaphthalen-2-yl)-4,6-diphenyl-1,3,5-triazine (CAS 1642848-97-2, 1 eq, 15.0 g), 4,4,5,5-tetramethyl-2-(3',4',5'-triphenyl-[1,1':2',1"-terphenyl]-3-yl)-1,3,2-dioxaborolane (CAS 872118-08-6, 1 eq, 20 g), [1,1'-bis(diphenylphosphino)ferrocene]dichloropalladium(II) (CAS 72287-26-4, 0.02 eq, 0,50 g), potassium carbonate (CAS 584-08-7, 2 eq, 9.44 g). Deaerated mixture of 170 ml dioxane and 34 ml water was added. Reaction was running at 55°C under a nitrogen atmosphere overnight. Next day, dense yellow suspension was formed. The reaction mixture was cooled down, the precipitate was filtered and washed with methanol and water, and dried at low pressure. The raw product was dissolved at elevated temperature in 300 ml chlorobenzene and filtered hot through a silica pad. The solvent was rotary evaporated to residual volume of the solution about 200 mL and the formed precipitate was filtered. Light yellow crystalline powder was obtained. Yield: 22.5 g (81 %).

**2,4-diphenyl-6-(1-(3-(3,5,6-triphenylpyrazin-2-yl)phenyl)naphthalen-2-yl)-1,3,5-triazine (G24)**

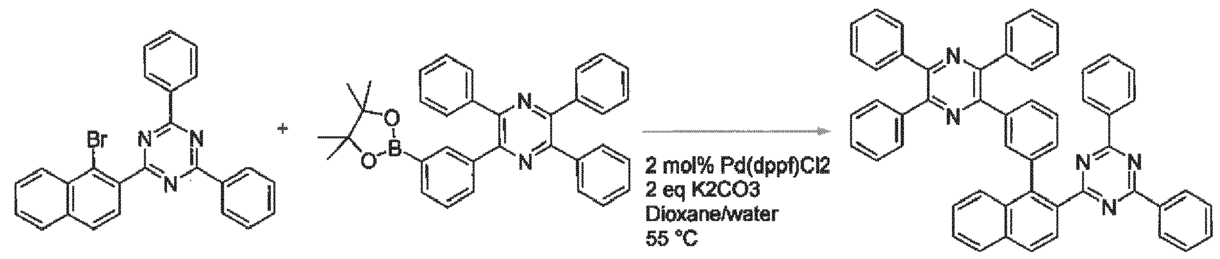


3-neck round-bottom flask was flushed with nitrogen and charged with 2-(1-bromonaphthalen-2-yl)-4,6-diphenyl-1,3,5-triazine (CAS 1642848-97-2, 1 eq, 15.0 g), 2,3,5-triphenyl-6-(3-(4,4,5,5-tetramethyl-1,3,2-dioxaborolan-2-yl)phenyl)pyrazine (CAS 2396743-64-7, 1 eq, 18.34 g), [1,1'-bis(diphenylphosphmo)ferrocene]dichloropalladium(II) (CAS 72287-26-4, 0.02 eq, 0.5 g), potassium carbonate (CAS 584-08-7,2 eq, 9.44 g). Deaerated mixture of 170 mL dioxane and 34 mL water was added. Reaction was running at 55°C under a nitrogen atmosphere overnight. Then the reaction mixture was cooled down and extracted with chloroform, the extract washed with water and filtered through silica pad. Solvent was evaporated and the product was recrystallized from chlorobenzene. Light yellow powder. Yield: 14.94 g (59 %).

**2,4-diphenyl-6-(1-(3',4'5'-triphenyl-[1,1':2',1"-terphenyl]-4-yl)naphthalen-2-yl)-1,3,5-triazine (G25)**

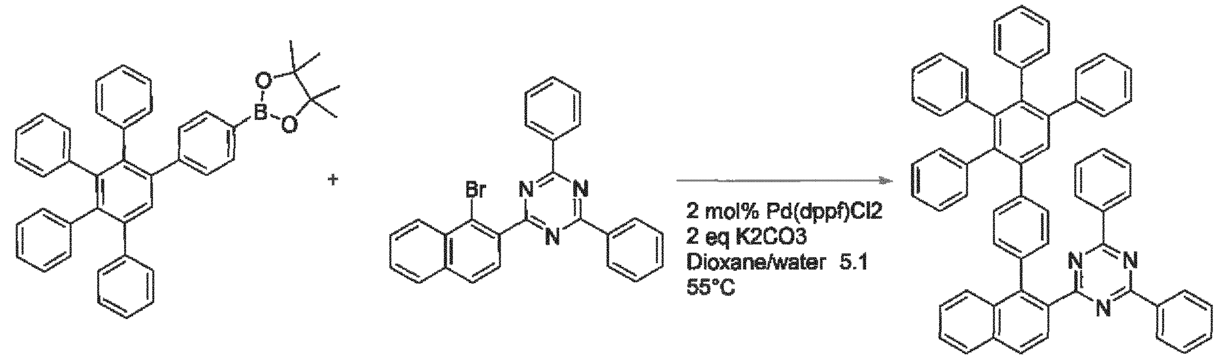


3-neck round-bottom flask was flushed with nitrogen and charged with 4,4,5,5-tetramethyl-2-(3',4',5'-triphenyl-[1,1':2',1"-terphenyl]-4-yl)-1,3,2-dioxaborolane (CAS 2122311-15-1, 1 eq, 25.0 g), 2-(1-bromonaphthalen-2-yl)-4,6-diphenyl-1,3,5-triazine (CAS 1642848-97-2, 1 eq, 18.75 g), [1,1'-bis(diphenylphosphino)ferrocene]dichloropalladium(II) (CAS 72287-26-4, 0.02 eq, 0.63 g), potassium carbonate (CAS 584-08-7, 2 eq, 11.8 g). Deaerated mixture of 214 mL dioxane and 43 mL water was added. Reaction was running at 55°C under a nitrogen atmosphere overnight. Thick yellow suspension formed, the reaction mixture was cooled down; the precipitate was filtered and washed with water and methanol. The raw product was dissolved at elevated temperature in 500 mL chlorobenzene and filtered hot through a silica pad. The solvent was evaporated and the product was recrystallized from 240 mL toluene/chlorobenzene mixture in volume ratio 6:4. White crystalline solid was obtained. Yield: 25.41 g (73 %).

**2-(1-(3',5'-diphenyl-[1,1':4',1"-terphenyl]-4-yl)naphthalen-2-yl)-4,6-diphenyl-1,3,5-triazine (G26)**

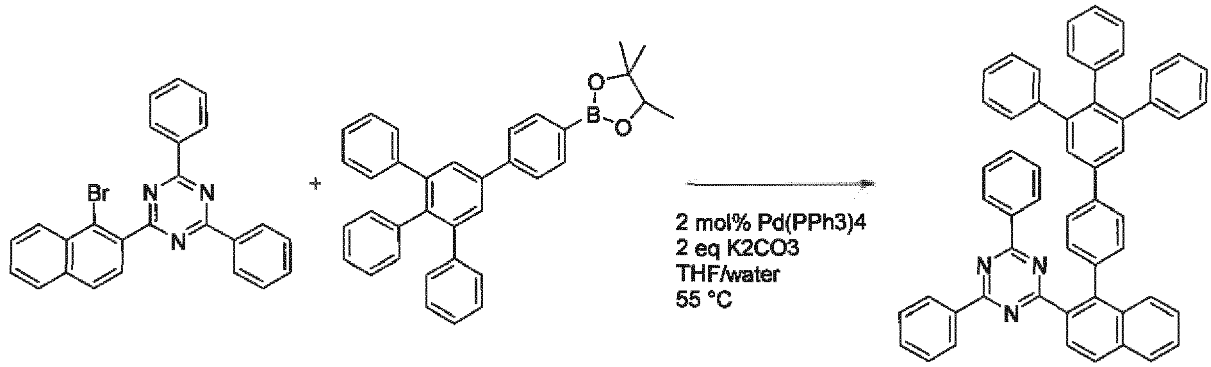


3-neck round-bottom flask was flushed with nitrogen and charged with 2-(1-bromonaphthalen-2-yl)-4,6-diphenyl-1,3,5-triazine (CAS 1642848-97-2, 1 eq, 20.0 g), 2-(3',5'-diphenyl-[1,1':4',1"-terphenyl]-4-yl)-4,4,5,5-tetramethyl-1,3,2-dioxaborolane (CAS 2358709-40-5, 1.05 eq, 24.36 g), tetrakis(triphenylphosphine)palladium(o) (CAS 14221-01-3, 0.02 eq, 1.05 g) and potassium carbonate (CAS 584-08-7, 2 eq, 12.6 g). Deaerated mixture of 280 mL THF and 46 mL water was added. The reaction was running at 55°C under a nitrogen atmosphere overnight. A thick orange suspension formed. The reaction mixture was cooled down; precipitate was filtered and washed with water and methanol. The raw product was dissolved at elevated temperature in 1300 mL chlorobenzene and hot filtered through silica pad. The solution was evaporated, the product was recrystallized from chlorobenzene and obtained as a white powder. Yield: 11.32 g (46 %).

**2,4-diphenyl-6-(4-(3',4',5'-triphenyl-[1,1':2',1"-terphenyl]-3-yl)naphthalen-1-yl)-1,3,5-triazine (G27)**

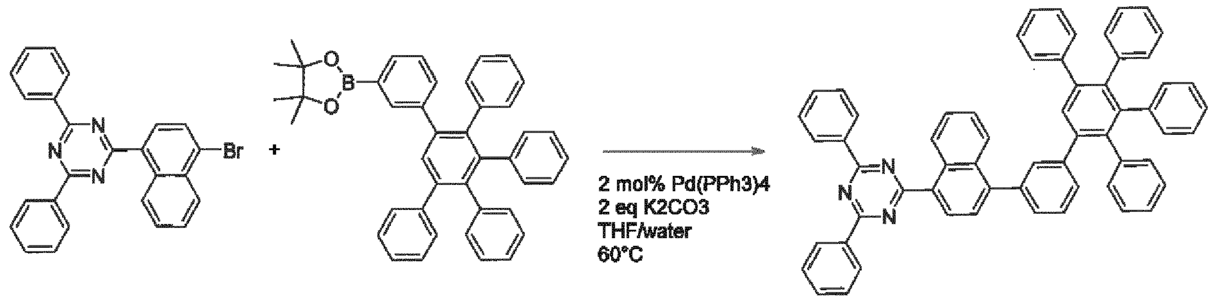


3-neck round-bottom flask was flushed with nitrogen and charged with 2-(4-bromonaphthalen-1-yl)-4,6-diphenyl-1,3,5-triazine (CAS 1800228-86-7, 1 eq, 20.0 g), 4,4,5,5-tetramethyl-2-(3',4',5'-triphenyl-[1,1':2',1"-terphenyl]-3-yl)-1,3,2-dioxaborolane (CAS 872118-08-6, 1.05 eq, 28.0 g), tetrakis(triphenylphosphine)palladium(o) (CAS 14221-01-3, 0.02 eq. 1.06 g), potassium carbonate (CAS 584-08-7, 2 eq, 12.62 g). Deaerated mixture of 340 mL THF and 47 mL water was added. Reaction was running at 60°C under a nitrogen atmosphere overnight. Then, the reaction mixture was cooled down and extracted with dichloromethane. The organic phase was filtered through silica pad, the solvent was evaporated, the crude product was recrystallized from mixture of isopropanol/cyclohexane with volume ratio 2:1 and obtained as a white powder. Yield: 18.5 g (50%).

Device experiments

Blue tandem OLED

Table 2a schematically describes the model device.

Table 2a

| Layer | Material | Volume % | thickness (nm) |
|---|---|---|---|
| Cap layer | F1 | 100 | 75 |
| Cathode | Ag:Mg | 90:10 | 13 |
| EIL | Yb | 100 | 1 |
| ETL2 | G3: LiQ | 50:50 | 31 |
| HBL | F4 | 100 | 5 |
| EML2 | H09:BD200 | 99:1 | 19 |
| EBL2 | F2 | 100 | 5 |
| HTL2 | F3 | 100 | 45 |
| p-CGL | F1:PD1 | 93:7 | 10 |
| n-CGL | various ETM:Yb | 98:2 | 7.5 |
| ETL1 | various ETM | 100 | 10 |
| EML1 | H09:BD200 | 99:1 | 19 |
| EBL | F2 | 100 | 5 |
| HTL1 | F1 | 100 | 29 |
| HIL | F1:PD1 | 98.5:1.5 | 10 |
| Anode | Ag | 100 | 100 |

F1 is

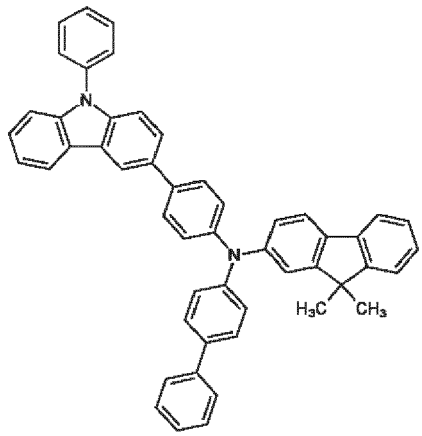

CAS 1242056-42-3 F2 is

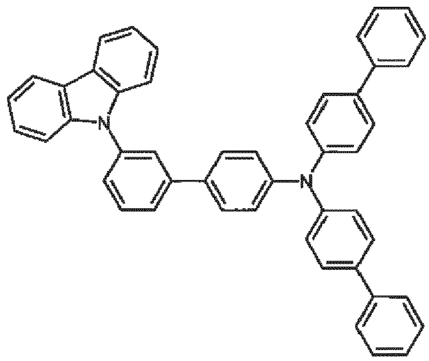

CAS 1464822-27-2 F3 is

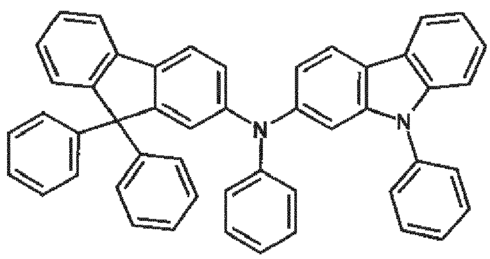

CAS 1607480-22-7 F4 is

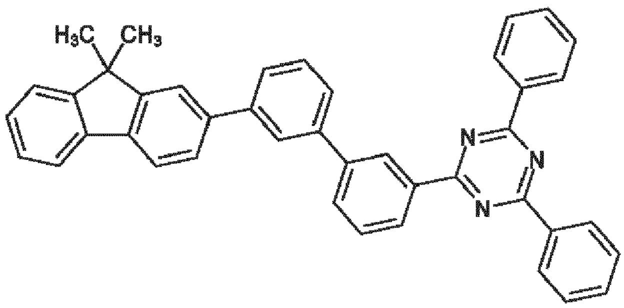

CAS 1955543-57-3 F5 is

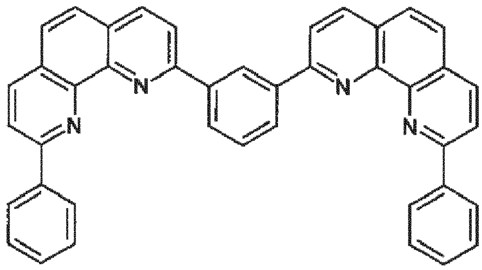

CAS 721969-94-4 PD1 is

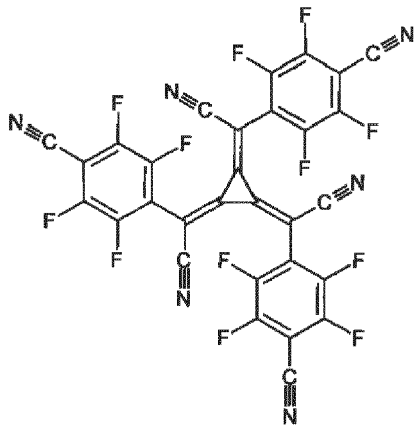

CAS 1224447-88-4

H09 is an emitter host and BD200 is a blue fluorescent emitter dopant, both commercially available from SFC, Korea.

The results of device experiments are provided in Table 2b

Table 2b

| ETM used as n-CGL matrix | ETM used as ETL1 matrix | Voltage U at 15 mA/cm$^2$ [V] | CEff/CIEy at 15 mA/cm$^2$ [cd/A] | Voltage rise dU at 30 mA/cm$^2$ [mV] |
|---|---|---|---|---|
| F5 | F5 | 6.82 | 230 | 230 |
| E1 | F5 | 6.72 | 230 | 126 |
| E2 | F5 | 6.64 | 229 | 123 |
| E1 | G1:G2 (2:8 v:v) | 6.84 | 228 | 98 |
| E1 | G2 | 6.75 | 235 | 181 |
| E1 | G6 | 7.07 | 221 | 94 |
| E1 | G5 | 6.71 | 234 | 143 |
| E1 | G4 | 6.68 | 236 | 156 |
| E1 | G28 | 6.81 | 236 | 187 |
| E1 | G12 | 6.73 | 238 | 193 |
| E1 | G8 | 6.77 | 239 | 200 |
| E1 | G7 | 6.94 | 222 | 95 |
| E1 | G10 | 6.70 | 234 | 138 |
| E1 | G9 | 6.69 | 204 | 243 |
| E1 | G14 | 6.74 | 231 | 135 |

(continued)

| ETM used as n-CGL matrix | ETM used as ETL1 matrix | Voltage U at 15 mA/cm$^2$ [V] | CEff/CIEy at 15 mA/cm$^2$ [cd/A] | Voltage rise dU at 30 mA/cm$^2$ [mV] |
|---|---|---|---|---|
| E1 | G13 | 6.81 | 237 | 192 |
| E1 | G15:G11 (2:8 v:v) | 6.71 | 234 | 202 |

The comparison with state-of-art device comprising F5 as n-CGL matrix shows that the inventive device exhibits improved voltage stability over a broad scale of various matrix materials for ETL1, without a substantial impairment of operational voltage U and/or without a substantial impairment of relative current efficiency CEff/CIEy.

The features disclosed in the foregoing description and in the dependent claims may, both separately and in any combination thereof, be material for realizing the aspects of the disclosure made in the independent claims, in diverse forms thereof.

## Claims

**1.** Organic light emitting device comprising an anode, a cathode, a first emission layer, a second emission layer, a charge generation layer and a first electron transport layer, wherein

- the charge generation layer is arranged between the first emission layer and the second emission layer;
- the charge generation layer comprises a n-doped sublayer;
- the n-doped sublayer comprises a metal and a n-doped sublayer matrix material;
- the n-doped sublayer matrix material comprises
    - a first structural moiety $R^a$, wherein $R^a$ is selected from the group consisting of phosphine oxide and substituted or unsubstituted pyridine, and
    - a second structural moiety $R^b$, wherein $R^b$ is a heteroaryl group comprising two nitrogen atoms in one ring thereof;
- the first electron transport layer is arranged adjacent to the n-doped sublayer and in direct contact therewith;
- the first electron transport layer is non-emissive;
- the first electron transport layer consists of a first electron transport layer matrix material;
- the first electron transport layer matrix material does not comprise an n-dopant; and
- the first electron transport layer matrix material does not comprise the n-doped sublayer matrix material.

**2.** Organic light emitting device according to claim 1, wherein the phosphine oxide is a dialkylphosphine oxide.

**3.** Organic light emitting device according to claim 1, wherein the heteroaryl group comprising two nitrogen atoms in one ring thereof is selected from the group consisting of diazine, diazole, benzimidazole, imidazopyridine, quinazoline and quinoxaline.

**4.** Organic light emitting device according to any of the preceding claims, wherein the n-doped sublayer matrix material comprises a third structural moiety $R^c$, wherein $R^c$ is selected from $C_6$ to $C_{60}$ aryl or $C_2$ to $C_{42}$ heteroaryl.

**5.** Organic light emitting device according to any of the preceding claims, wherein $R^c$

- is $C_6$ to $C_{60}$ and comprises 2 to 6 condensed aromatic rings; or
- is $C_2$ to $C_{42}$ heteroaryl and is represented by the following formula (IIb)

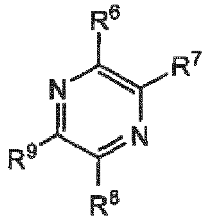

(IIb)

wherein $R^6$ to $R^9$ are independently selected from the group consisting of H, $C_6$ to $C_{12}$ aryl and $C_4$ to $C_{10}$ heteroaryl.

6. Organic light emitting device according to any of the preceding claims, wherein $R^c$ comprises a group selected from the group consisting of anthracene, phenanthrene, pyrene and a group of the following formula (IIb)

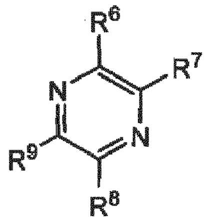

(IIb)

wherein $R^6$ to $R^9$ are phenyl.

7. Organic light emitting device according to any of the preceding claims, wherein the n-doped sublayer matrix material comprises a n-doped sublayer matrix compound and the n-doped sublayer matrix compound comprises $R^1$, $R^2$ and, if present, R3.

8. Organic light emitting device according to claim 7, wherein the n-doped sublayer matrix compound is represented by formula (III) or formula (IV)

- $R^1$-$R^2$-$R^3$ (III);

- $R^1$-$R^3$-$R^2$ (IV).

9. Organic light emitting device according to any of the claims 7 or 8, wherein the n-doped sublayer matrix compound is selected from the following structures E1 to E3

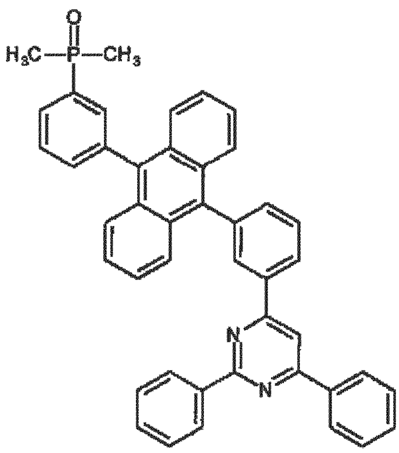

E1

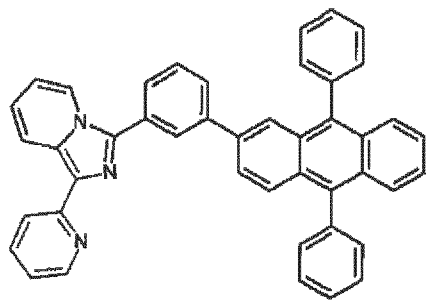

E2

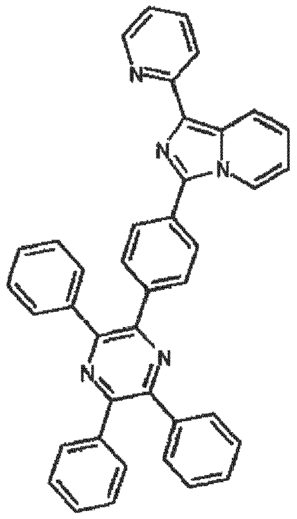

E3.

**10.** Organic light emitting device according to any of the preceding claims, wherein first electron transport layer matrix material comprises a first electron transport layer matrix compound of (i) Formula (I)

$(Ar^1\text{-Ac})a\text{-}Xb$ (I);

wherein

- a and b are independently 1 or 2;
- c is independently 0 or 1;
- $Ar^1$ is independently selected from $C_6$ to $C_{60}$ aryl or $C_2$ to $C_{42}$ heteroaryl,
  - wherein each $Ar^1$ may be substituted with one or two substituents independently selected from the group consisting of $C_6$ to $C_{12}$ aryl, $C_3$ to $C_{11}$ heteroaryl, and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;
  - wherein each $C_6$ to $C_{12}$ aryl substituent on $Ar^1$ and each $C_3$ to $C_{11}$ heteroaryl substituent on $Ar^1$ may be substituted with $C_1$ to $C_4$ alkyl or halogen;
- A is independently selected from $C_6$ to $C_{30}$ aryl,
  - wherein each A may be substituted with one or two substituents independently selected from the group consisting of $C_6$ to $C_{12}$ aryl and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;
  - wherein each $C_6$ to $C_{12}$ aryl substituent on A may be substituted with $C_1$ to $C_4$ alkyl or halogen; and
- X is independently selected from the group consisting of $C_2$ to $C_{42}$ heteroaryl and $C_6$ to $C_{60}$ aryl,
  - wherein each X may be substituted with one or two substituents independently selected from the group consisting of $C_6$ to $C_{12}$ aryl, $C_3$ to $C_{11}$ heteroaryl, and $C_1$ to $C_6$ alkyl, D, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$

to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{10})_2$, wherein Y is selected from O, S or Se, preferably O, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and
- wherein each $C_6$ to $C_{12}$ aryl substituent on X and each $C_3$ to $C_{11}$ heteroaryl substituent on X may be substituted with $C_1$ to $C_4$ alkyl or halogen,

and/or
(ii) Formula (II)

$$E\text{-}A^1\text{-}A^2\text{-}A^3 \qquad (II),$$

wherein in Formula (II)
- E is selected from the group consisting of a substituted or unsubstituted $C_4$-$C_{70}$ heteroaryl comprising a diazine group, a substituted or unsubstituted $C_3$-$C_{70}$ heteroaryl comprising a triazine group, a $C_{10}$-$C_{70}$ aryl comprising at least two condensed benzene rings, and a $C_4$-$C_{70}$ heteroaryl comprising at least two condensed aromatic rings;

- wherein in case that E is substituted or unsubstituted $C_4$-$C_{70}$ heteroaryl comprising a diazine group E is bonded to $A^1$ via a direct bond between $A^1$ and the diazine group;
- wherein in case that E is substituted or unsubstituted $C_4$-$C_{70}$ heteroaryl comprising a triazine group E is bonded to $A^1$ via a direct bond between $A^1$ and the triazine group;
- wherein in case that E is $C_{10}$-$C_{70}$ aryl comprising at least two condensed benzene rings E is bonded to $A^1$ via a direct bond between $A^1$ and one of the condensed benzene rings; and
- wherein in case that E is $C_4$-$C_{70}$ heteroaryl comprising at least two condensed aromatic rings E is bonded to $A^1$ via a direct bond between $A^1$ and one of the condensed aromatic rings;

- $A^1$ is selected from the group consisting of a substituted or unsubstituted $C_{10}$-$C_{70}$ arylene comprising 2 or 3 condensed rings and a substituted or unsubstituted $C_2$-$C_{70}$ a heteroarylene comprising 2 or 3 condensed rings; wherein $A^1$ is bonded to E via a direct bond between one of the condensed rings and E; and wherein $A^1$ is bonded to $A^2$ via a direct bond between one of the condensed rings and $A^2$;
- $A^2$ is selected from the group consisting of a substituted or unsubstituted carbocyclic aromatic ring, a substituted or unsubstituted heterocyclic aromatic ring, a substituted or unsubstituted condensed bicyclic aromatic system and a substituted or unsubstituted condesned bicyclic heteroaromatic system; wherein $A^2$ is bonded to $A^3$ via a direct bond between one of the aromatic or heteroaromatic rings and $A^3$; and

- $A^3$ is selected from the group consisting of a monocyclic aryl and a monocyclic heteroaryl, wherein $A^3$ is substituted with at least three groups independently selected from the group consisting of substituted or unsubstituted $C_6$-$C_{18}$ aryl and $C_2$-$C_{18}$ heteroaryl.

**11.** Organic light emitting device according to any of the preceding claims, wherein the first electron transport layer matrix compound is selected from the following structures G1 to G28

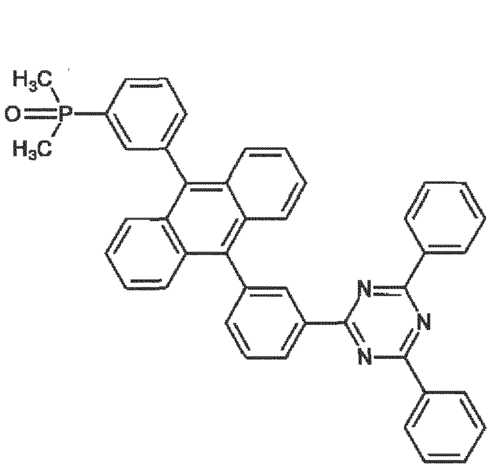

G1

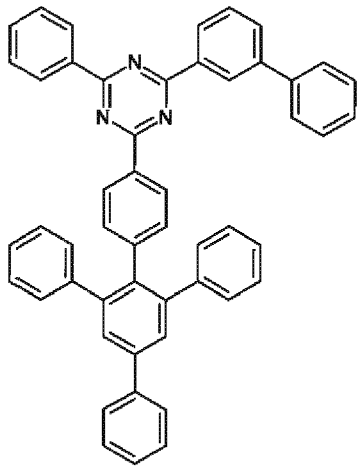

G2

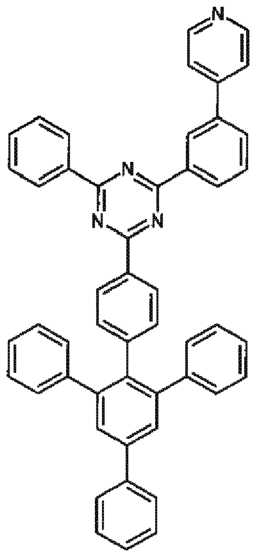

G3

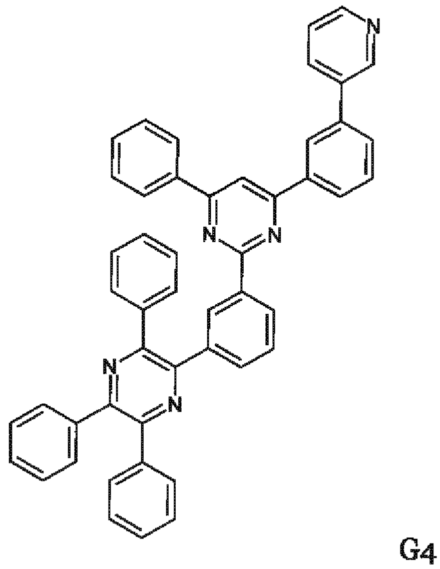

G4

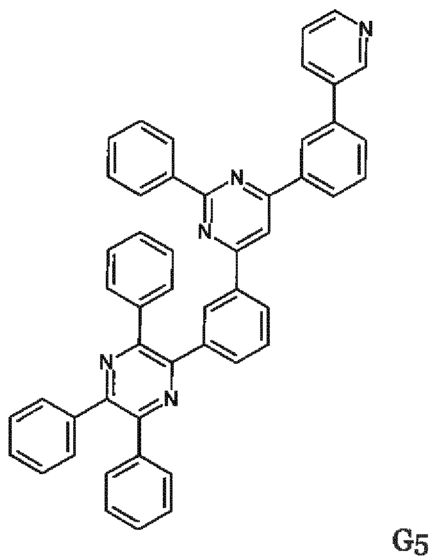

G5

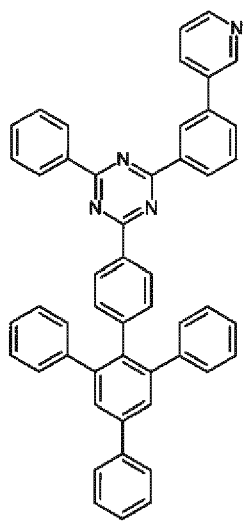

G6

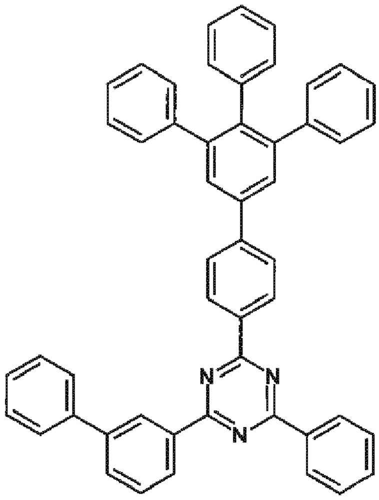

G7

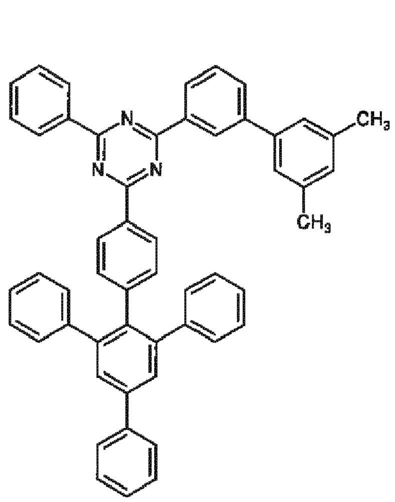

G8

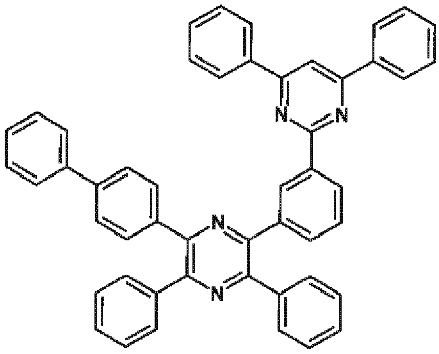

G9

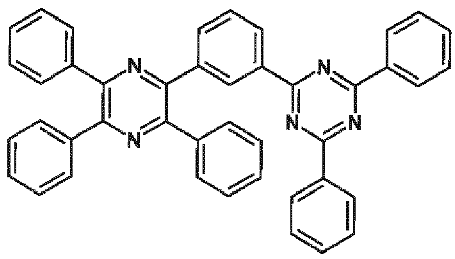

G10

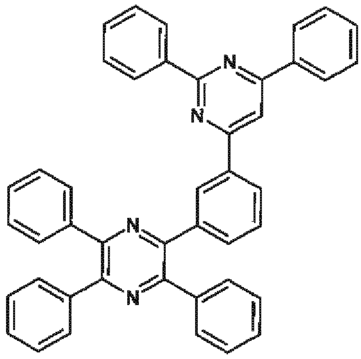

G11

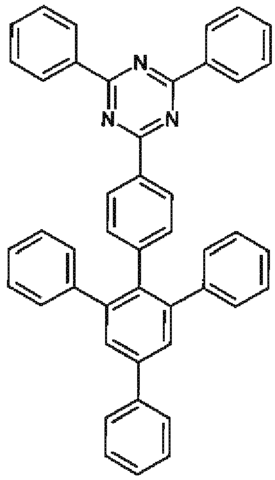

G12

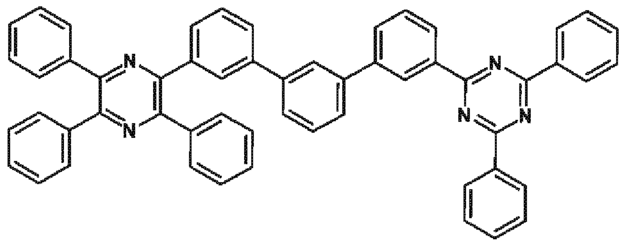

G13

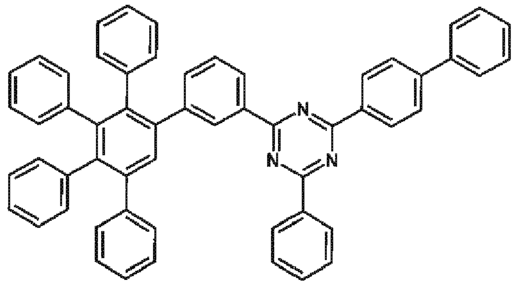

G14

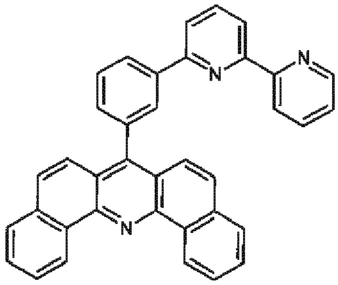

G15

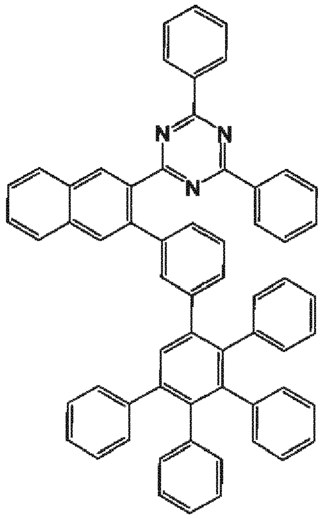

G16

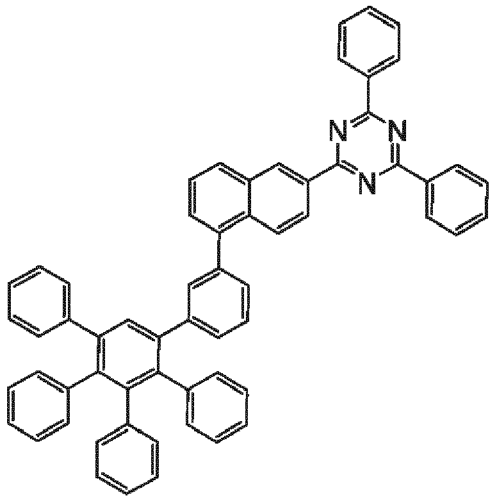

G17

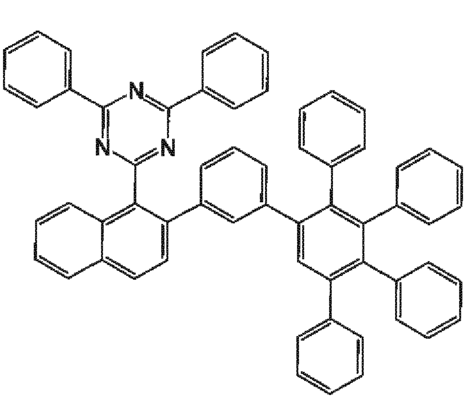

G18

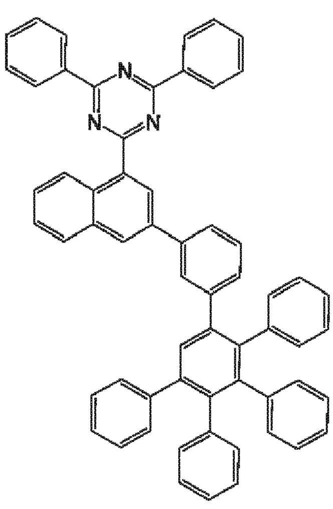

G19

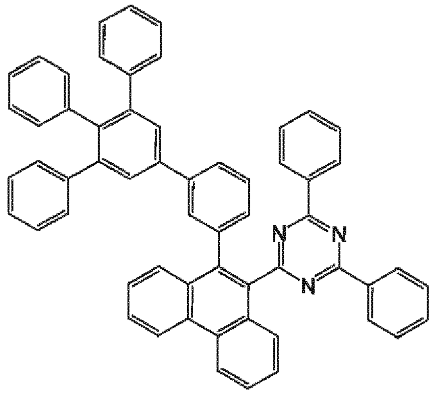

G20

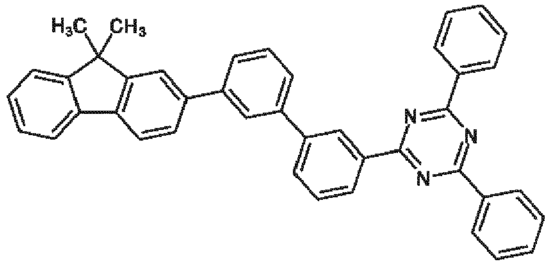

G21

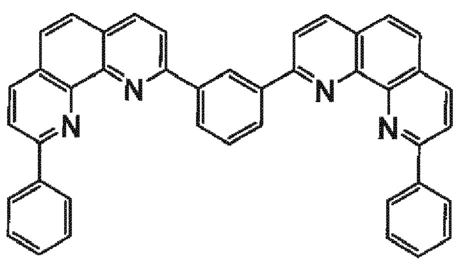

G22

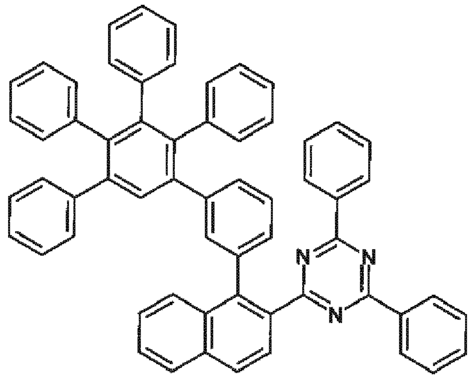

G23

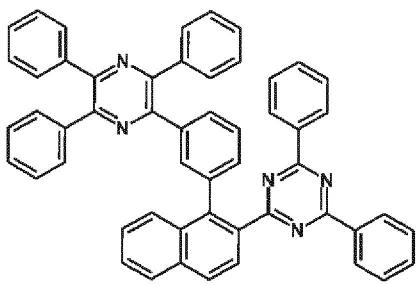

G24

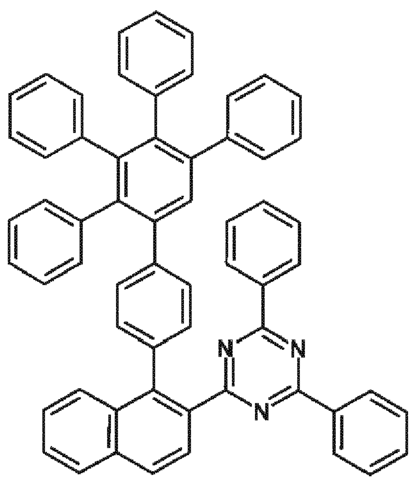

G25

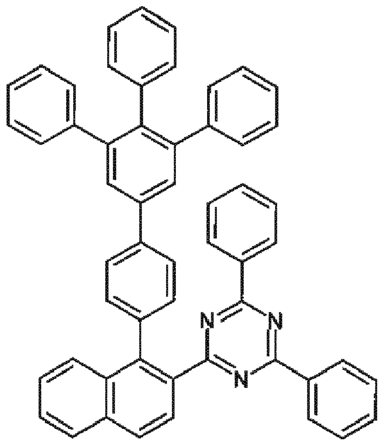

G26

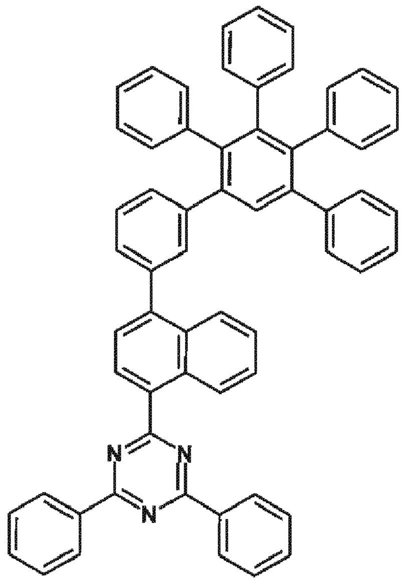

G27

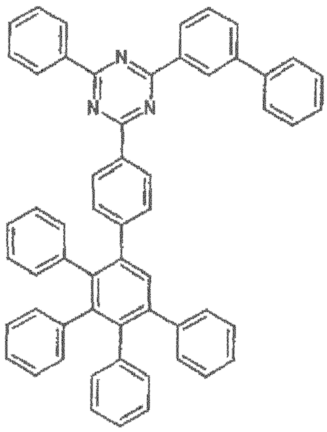

G28.

**12.** Organic light emitting device according to any of the preceding claims, wherein the first electron transport layer matrix material comprises a first electron transport layer matrix compound and a second electron transport layer matrix compound.

**13.** Organic light emitting device according to any of the preceding claims, wherein the metal is selected from alkali metals, alkaline earth metals, transition metals of the third period of the Periodic Table, and rare earth metals.

**14.** Display device comprising the organic light emitting device according to any of the preceding claims.

**15.** Compound having a formula selected from E2, G2 to G5, G7, and G9 to G11

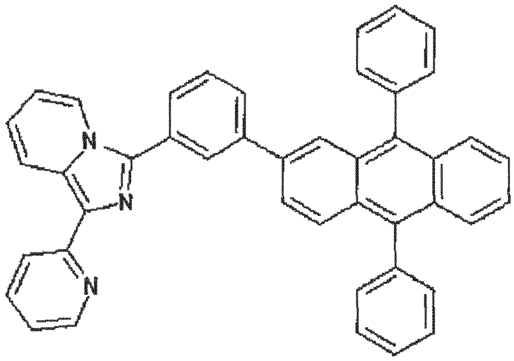

E2

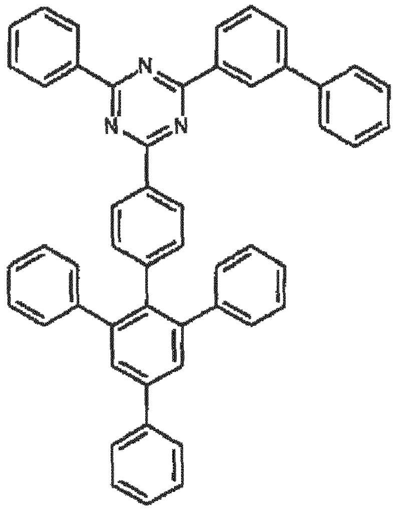

G2

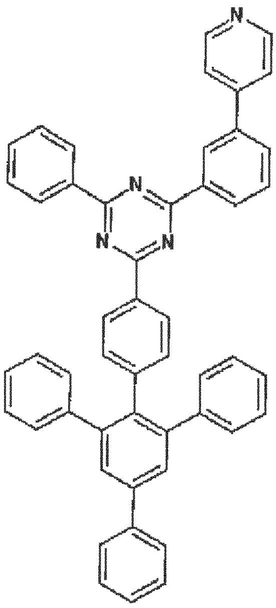

G3

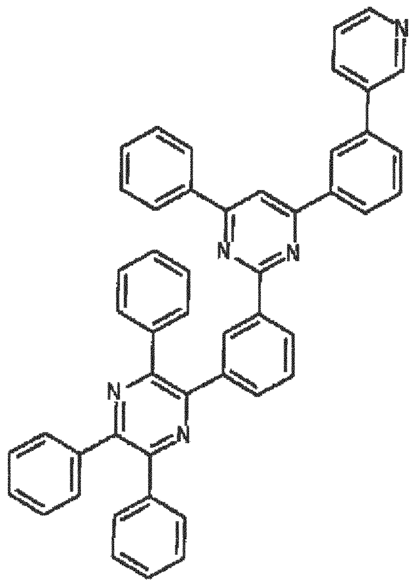

G4

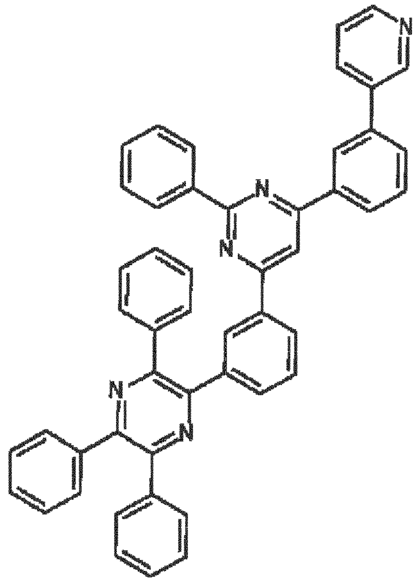

G5

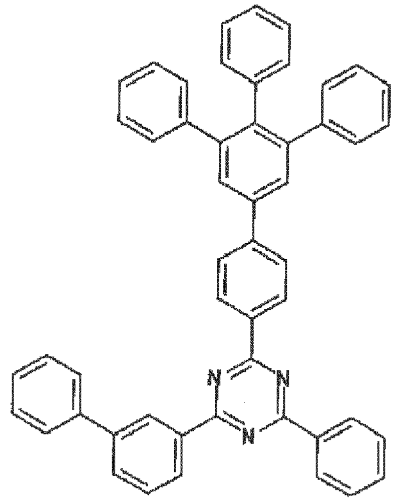

G7

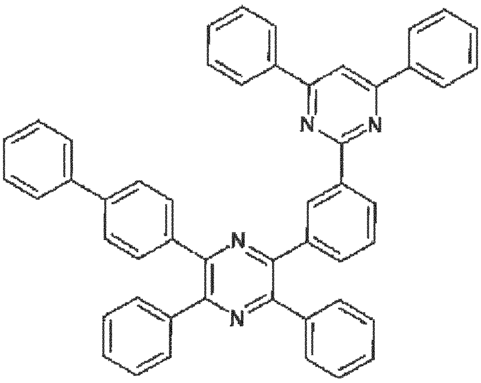

G9

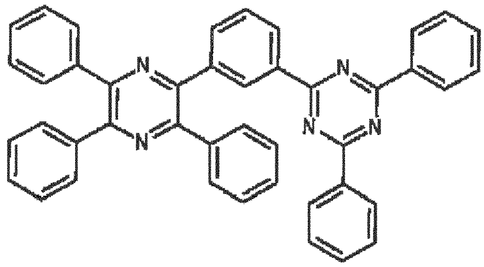

G10

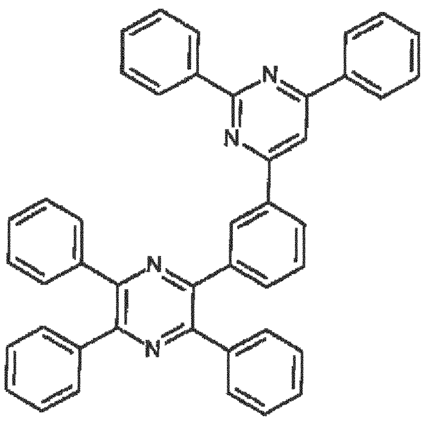

G11.

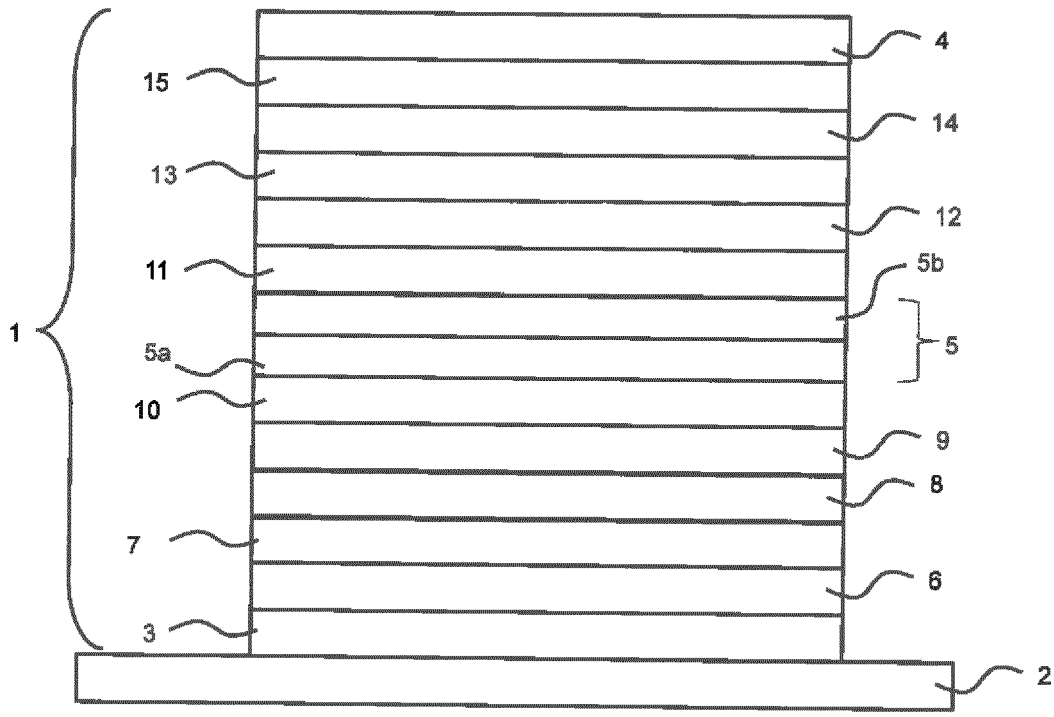


Fig. 1

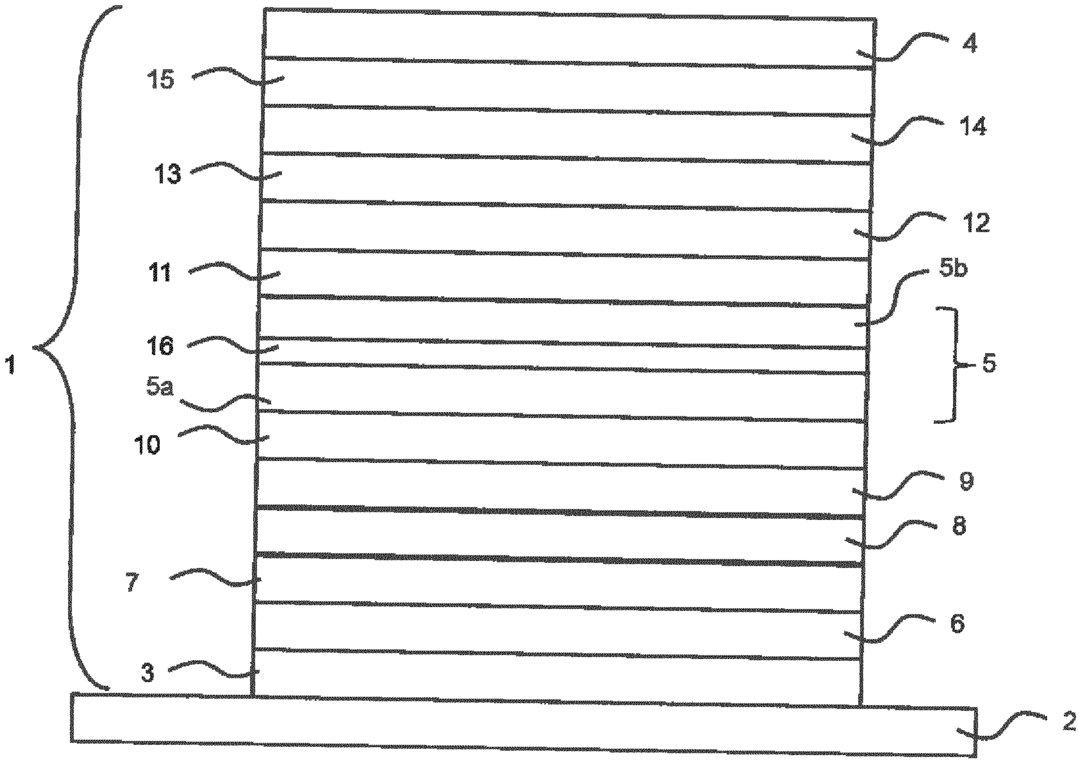


Fig. 2

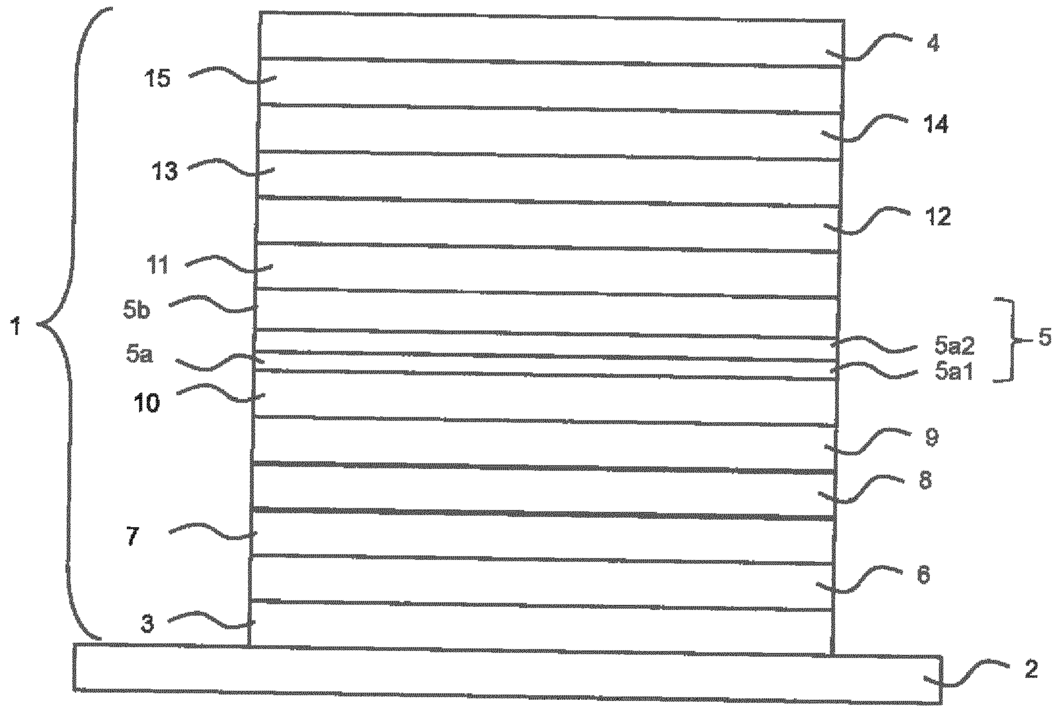


Fig. 3

Europäisches Patentamt
European Patent Office
Office européen des brevets

# EUROPEAN SEARCH REPORT

Application Number
EP 21 21 6026

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | EP 3 229 289 A1 (SAMSUNG DISPLAY CO LTD [KR]) 11 October 2017 (2017-10-11)<br>* example 3; table 1; compounds compound 1-16, Bphen *<br>----- | 1-11,13<br>12,14 | INV.<br>H01L51/54 |
| X<br>Y | EP 3 923 364 A1 (NOVALED GMBH [DE]) 15 December 2021 (2021-12-15)<br>* page 30; claims 17,18; table 7; compounds C-4 *<br>----- | 15<br>12,14 | |
| X | EP 3 828 951 A1 (NOVALED GMBH [DE]) 2 June 2021 (2021-06-02)<br>* page 13; compound A10 *<br>----- | 15 | |
| X | EP 3 805 206 A1 (NOVALED GMBH [DE]) 14 April 2021 (2021-04-14)<br>* page 32; compounds M-1 *<br>----- | 15 | |
| X | EP 3 895 227 A1 (NOVALED GMBH [DE]) 20 October 2021 (2021-10-20)<br>* page 7; compound E4 *<br>----- | 15 | TECHNICAL FIELDS SEARCHED (IPC)<br>H01L |

The present search report has been drawn up for all claims

1

| Place of search | Date of completion of the search | Examiner |
|---|---|---|
| The Hague | 31 May 2022 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 21 21 6026

This annex lists the patent family members relating to the patent documents cited in the above-mentioned European search report. The members are as contained in the European Patent Office EDP file on
The European Patent Office is in no way liable for these particulars which are merely given for the purpose of information.

31-05-2022

| Patent document cited in search report | Publication date | Patent family member(s) | Publication date |
|---|---|---|---|
| EP 3229289 A1 | 11-10-2017 | CN 107267138 A | 20-10-2017 |
| | | EP 3229289 A1 | 11-10-2017 |
| | | KR 20170116301 A | 19-10-2017 |
| | | US 2017294587 A1 | 12-10-2017 |
| EP 3923364 A1 | 15-12-2021 | EP 3923364 A1 | 15-12-2021 |
| | | WO 2021250277 A1 | 16-12-2021 |
| EP 3828951 A1 | 02-06-2021 | EP 3828951 A1 | 02-06-2021 |
| | | WO 2021105518 A1 | 03-06-2021 |
| EP 3805206 A1 | 14-04-2021 | CN 114555580 A | 27-05-2022 |
| | | EP 3805206 A1 | 14-04-2021 |
| | | WO 2021069595 A1 | 15-04-2021 |
| EP 3895227 A1 | 20-10-2021 | CN 113228325 A | 06-08-2021 |
| | | EP 3895227 A1 | 20-10-2021 |
| | | JP 2022511943 A | 01-02-2022 |
| | | KR 20210104100 A | 24-08-2021 |
| | | US 2022037595 A1 | 03-02-2022 |
| | | WO 2020120793 A1 | 18-06-2020 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 1837926 A1
- WO 07107306 A1
- WO 07107356 A1
- EP 2722908 A1
- EP 1970371 A1
- WO 2013079217 A1
- WO 2021069595 A
- WO 2019121672 A
- WO 2021009206 A
- WO 2019238858 A
- WO 2021105518 A


### Non-patent literature cited in the description


- **YASUHIKO SHIROTA ; HIROSHI KAGEYAMA.** *Chem. Rev.,* 2007, vol. 107, 953-1010
- *DIN EN ISO 11357,* March 2010
- *CHEMICAL ABSTRACTS,* 1642848-97-2
- *CHEMICAL ABSTRACTS,* 872118-08-6
- *CHEMICAL ABSTRACTS,* 72287-26-4
- *CHEMICAL ABSTRACTS,* 584-08-7
- *CHEMICAL ABSTRACTS,* 2396743-64-7
- *CHEMICAL ABSTRACTS,* 2122311-15-1
- *CHEMICAL ABSTRACTS,* 2358709-40-5
- *CHEMICAL ABSTRACTS,* 14221-01-3
- *CHEMICAL ABSTRACTS,* 1800228-86-7
- *CHEMICAL ABSTRACTS,* 1242056-42-3
- *CHEMICAL ABSTRACTS,* 1464822-27-2
- *CHEMICAL ABSTRACTS,* 1607480-22-7
- *CHEMICAL ABSTRACTS,* 1955543-57-3
- *CHEMICAL ABSTRACTS,* 721969-94-4
- *CHEMICAL ABSTRACTS,* 1224447-88-4